(19) Europäisches Patentamt
European Patent Office
Office européen des brevets

(11) EP 4 775 952 A1

(12) **EUROPEAN PATENT APPLICATION**
published in accordance with Art. 153(4) EPC

(43) Date of publication:
15.07.2026 Bulletin 2026/29

(21) Application number: 23951465.6

(22) Date of filing: 06.09.2023

(51) International Patent Classification (IPC):
$G01N\ 21/01^{(2006.01)}$  $G01N\ 21/64^{(2006.01)}$
$G01N\ 21/956^{(2006.01)}$  $H01L\ 21/66^{(2006.01)}$

(52) Cooperative Patent Classification (CPC):
G01N 21/01; G01N 21/64; G01N 21/956;
H10P 74/00

(86) International application number:
PCT/JP2023/032456

(87) International publication number:
WO 2025/052563 (13.03.2025 Gazette 2025/11)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicant: NIKON CORPORATION
Tokyo 1408601 (JP)

(72) Inventor: NIITANI, Yamato
Tokyo 1408601 (JP)

(74) Representative: Hoffmann Eitle
Patent- und Rechtsanwälte PartmbB
Arabellastraße 30
81925 München (DE)

(54) **OPTICAL DEVICE FOR INSPECTION, DEFECT INSPECTION DEVICE, IRRADIATION OPTICAL SYSTEM, AND INSPECTION METHOD**

(57) A numerical aperture setting member (39) of a first irradiation optical system (30) sets an illumination numerical aperture of first irradiation light (La) when a distance in a Z direction (an optical axis direction of the first irradiation optical system (30)) between a substrate (WF1) and a light collection position of the first irradiation light (La) is a second distance longer than a first distance to be smaller than an illumination numerical aperture of the first irradiation light (La) when the distance in the Z direction between the substrate (WF1) and the light collection position of the first irradiation light (La) is the first distance.

FIG.1

**Description**

TECHNICAL FIELD

The present invention relates to an inspection optical apparatus, a defect inspection apparatus, an irradiation optical system, and an inspection method.

TECHNICAL BACKGROUND

Among substrate inspection apparatuses, an inspection apparatus exists that irradiates a surface of a substrate with laser light, detects reflected light, scattered light, and the like of the laser light, and inspects the surface of the substrate for a defect (for example, see Patent Literature 1). In such an inspection apparatus, it is required to effectively utilize the light with which the substrate is irradiated.

PRIOR ARTS LIST

PATENT DOCUMENT

Patent Literature 1: U.S. Patent No. 6798504

SUMMARY OF THE INVENTION

An inspection optical apparatus according to a first aspect of the present invention is an inspection optical apparatus used for inspecting a substrate, the inspection optical apparatus comprising: an irradiation optical system that directs irradiation light toward the substrate and collects the irradiation light inside the substrate; a receiving optical system that receives light produced inside the substrate by the irradiation light with which the substrate is irradiated; and a distance changing apparatus that changes, in an optical axis direction of the irradiation optical system, a distance between the substrate and a light collection position of the irradiation light, wherein the irradiation optical system comprises a numerical aperture setting member that sets a numerical aperture of the irradiation light when the distance is a second distance longer than a first distance to be smaller than a numerical aperture of the irradiation light when the distance is the first distance.

An inspection optical apparatus according to a second aspect of the present invention is an inspection optical apparatus used for inspecting a substrate, the inspection optical apparatus comprising: an irradiation optical system that directs irradiation light toward the substrate and collects the irradiation light inside the substrate; and a receiving optical system that receives light produced inside the substrate by the irradiation light with which the substrate is irradiated, wherein the irradiation optical system comprises a numerical aperture setting member that sets a numerical aperture to collect the irradiation light, the numerical aperture being set such that the following conditional expression is satisfied:

**[Expression 1]**

$$-0.05 < \frac{NAi}{nim} + 0.2552 \times \log_{10} \frac{nim \times z}{\lambda} - f(t) < 0.05$$

where NAi: the numerical aperture;

nim: a refractive index of a medium between the substrate and the irradiation optical system;
z: a position in an optical axis direction of a focal point of the irradiation optical system, with a surface of the substrate opposite the irradiation optical system as a reference position;
$\lambda$: a wavelength of the irradiation light; and
f(t): a function of t, defined by the following expression when a refractive index of the substrate is nsa and t = nsa/nim.

$$f(t) = 1.068 - 0.006502t + 3.837\exp(-3.175t)$$

A defect inspection apparatus according to the present invention comprises the above-described inspection optical apparatus, wherein the substrate is inspected for a defect, based on the information about the inside of the substrate generated by the inspection optical apparatus.

An irradiation optical system according to the present invention is an irradiation optical system that directs irradiation light toward a substrate and collects the irradiation light inside the substrate, the irradiation optical system comprising: a numerical aperture setting member that sets a numerical aperture to collect the irradiation light, the numerical aperture being set such that the following conditional expression is satisfied:

**[Expression 2]**

$$-0.05 < \frac{NAi}{nim} + 0.2552 \times \log_{10} \frac{nim \times z}{\lambda} - f(t) < 0.05$$

where NAi: the numerical aperture;

nim: a refractive index of a medium between the substrate and the irradiation optical system;
z: a position in an optical axis direction of a focal point of the irradiation optical system, with a surface of the substrate opposite the irradiation optical system as a reference position;
λ: a wavelength of the irradiation light; and
f(t): a function of t, defined by the following expression when a refractive index of the substrate is nsa and t = nsa/nim.

$$f(t) = 1.068 - 0.006502t + 3.837\exp(-3.175t)$$

An inspection method according to a first aspect of the present invention is an inspection method for a substrate, the inspection method comprising: directing irradiation light toward the substrate and collecting the irradiation light inside the substrate; receiving light produced inside the substrate by the irradiation light with which the substrate is irradiated; and changing, in an optical axis direction of the irradiation optical system, a distance between the substrate and a light collection position of the irradiation light, wherein when collecting the irradiation light, a numerical aperture of the irradiation light when the distance is a second distance longer than a first distance is set to be smaller than a numerical aperture of the irradiation light when the distance is the first distance.

An inspection method according to a second aspect of the present invention is an inspection method for a substrate, the inspection method comprising: directing irradiation light toward the substrate and collecting the irradiation light inside the substrate; and receiving light produced inside the substrate by the irradiation light with which the substrate is irradiated, wherein when collecting the irradiation light, a numerical aperture is set to collect the irradiation light, the numerical aperture being set such that the following conditional expression is satisfied:

**[Expression 3]**

$$-0.05 < \frac{NAi}{nim} + 0.2552 \times \log_{10} \frac{nim \times z}{\lambda} - f(t) < 0.05$$

where NAi: the numerical aperture;

nim: a refractive index of a medium between the substrate and the irradiation optical system;
z: a position in an optical axis direction of a focal point of the irradiation optical system, with a surface of the substrate opposite the irradiation optical system as a reference position;
λ: a wavelength of the irradiation light; and
f(t): a function of t, defined by the following expression when a refractive index of the substrate is nsa and t = nsa/nim.

$$f(t) = 1.068 - 0.006502t + 3.837\exp(-3.175t)$$

BRIEF DESCRIPTION OF THE DRAWINGS

FIG. 1 is a schematic configuration diagram showing a defect inspection apparatus according to a first embodiment;
FIG. 2 is a graph for describing a beam diameter of first irradiation light;
FIG. 3 is a schematic diagram showing a relationship between the beam diameter of the first irradiation light and an aperture diameter of an objective optical system;

FIG. 4 is a schematic configuration diagram showing a surface detection unit;

FIG. 5 is a schematic diagram showing a state in which an image forming position of an image of a slit aperture of second irradiation light coincides with a focal position of the objective optical system;

FIG. 6 is a schematic diagram showing a state in which the image forming position of the image of the slit aperture of the second irradiation light is separated from the focal position of the objective optical system;

FIG. 7 is a schematic diagram showing a state in which the image forming position of the image of the slit aperture of the second irradiation light is located on a surface of a substrate;

FIG. 8 is a graph showing a relationship between a focal position and a numerical aperture of a first irradiation optical system when a refractive index of the substrate is 1.4;

FIG. 9 is a graph showing a relationship between the focal position and the numerical aperture of the first irradiation optical system when the refractive index of the substrate is 4.0;

FIG. 10 illustrates first graphs for comparing and showing relationships between a function v and a peak intensity in a point spread function;

FIG. 11 illustrates second graphs for comparing and showing relationships between the function v and the peak intensity in a point spread function;

FIG. 12 illustrates third graphs for comparing and showing relationships between the function v and the peak intensity in a point spread function;

FIG. 13 is a flowchart showing an inspection method for the substrate;

FIG. 14 is a schematic diagram showing an example in which a light collection position of the first irradiation light is set inside the substrate; and

FIG. 15 is a schematic configuration diagram showing a defect inspection apparatus according to a second embodiment.

DESCRIPTION OF THE EMBODIMENTS

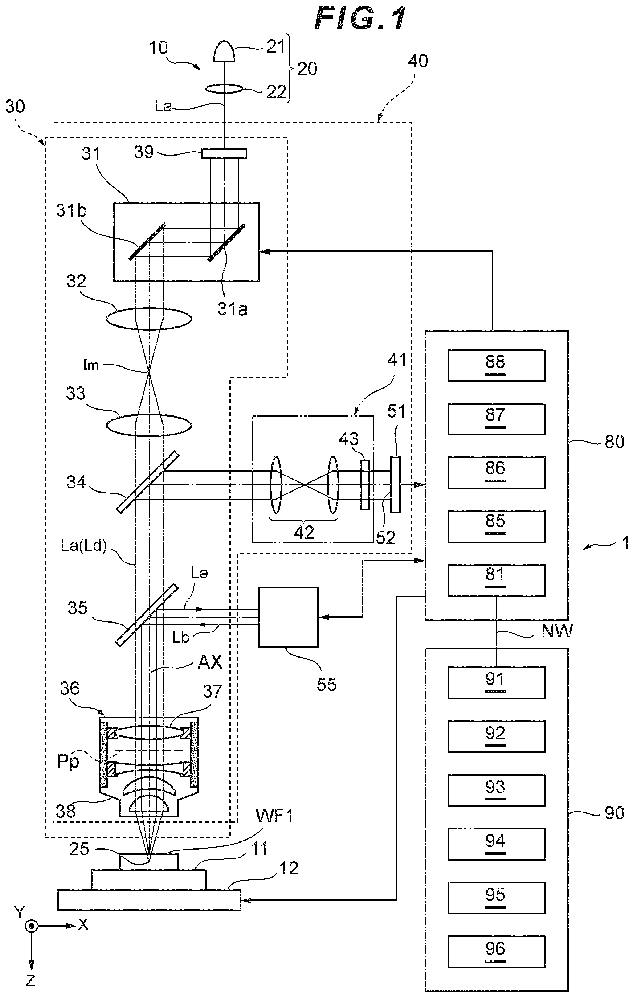

Hereinafter, preferred embodiments will be described. In the following description, directions indicated by each arrow in FIG. 1 may be referred to as an X direction, a Y direction, and a Z direction. The X direction, the Y direction, and the Z direction are directions orthogonal to each other. The Z direction is a direction parallel to an optical axis AX of an objective optical system 36. A coordinate position in the X direction may be referred to as an X position, a coordinate position in the Y direction may be referred to as a Y position, and a coordinate position in the Z direction may be referred to as a Z position.

First Embodiment

First, a defect inspection apparatus 1 according to a first embodiment will be described. As shown in FIG. 1, the defect inspection apparatus 1 according to the first embodiment comprises an inspection optical apparatus 10 and an information processing apparatus 90. The inspection optical apparatus 10 and the information processing apparatus 90 can transmit and receive data to and from each other via a network cable NW. The inspection optical apparatus 10 is also referred to as a scanning microscope. The inspection optical apparatus 10 comprises a stage 11 on which a substrate WF1 is placed, a first light source unit 20, a first irradiation optical system 30, a first light reception section 40, a surface detection unit 55, and an optical apparatus control section 80.

The stage 11 supports the substrate WF1 being an inspection object. The substrate WF1 may be a substrate used for manufacturing a power device (power semiconductors) such as a high-electron-mobility transistor (HEMT). Such a substrate may, for example, comprise at least one of a layer made of gallium nitride (GaN), a layer made of C-GaN, or a layer made of aluminum gallium nitride (AlGaN). Hereinafter, a substrate in which at least one layer is formed using GaN may be referred to as a GaN substrate.

A stage moving part 12 is provided at the stage 11. The stage moving part 12 moves the stage 11 in a direction perpendicular to the optical axis AX (the Z direction) of the objective optical system 36 in the first irradiation optical system 30, that is, in the X direction and the Y direction. By moving the stage 11 in the X direction and the Y direction (the directions perpendicular to the optical axis AX of the objective optical system 36) with the stage moving part 12, an observation region of the substrate WF1 opposite the objective optical system 36 can be displaced in the X direction and the Y direction (directions along a cross-section of the substrate WF1). Note that the observation region is part of the substrate WF1 that is scanned by a deflection scanning section 31 to be described below via the objective optical system 36. The observation region may be set to a narrower range than an actual field of view of the inspection optical apparatus 10, or may be set to the same range as the actual field of view of the inspection optical apparatus 10.

The stage moving part 12 can move the stage 11 in the direction along the optical axis AX of the objective optical system 36, that is, in the Z direction. Upon moving the stage 11 in the Z direction with the stage moving part 12, a relative position of the objective optical system 36 with respect to the substrate WF1 supported by the stage 11 changes in the Z direction, and a focal position of the first irradiation optical system 30 (a position of focus of the first irradiation optical system 30) changes in the Z direction by the same amount as the movement of the stage 11. Note that the focal position of the first irradiation optical system 30 is a light collection position of first irradiation light La in accordance with optical system design conditions. When the light collection position of the first irradiation light La is located inside the substrate WF1 as in the present embodiment, the focal position of the first irradiation optical system 30 differs from the light collection position of the first irradiation light La inside the substrate WF1 since a refractive index of the substrate WF1 differs from the optical system design conditions. Here, by changing the focal position of the first irradiation optical system 30 in the Z direction, the light collection position of the first irradiation light La also changes inside the substrate WF1 in the Z direction, making it possible to acquire an image of a plurality of cross-sections with different Z positions (positions in the direction along the optical axis AX of the objective optical system 36) in the substrate WF1. Hereinafter, the direction along the optical axis AX of the objective optical system 36 in the first irradiation optical system 30 may be referred to as an optical axis direction of the objective optical system 36 or an optical axis direction of the first irradiation optical system 30.

The first light source unit 20 emits the first irradiation light La toward the first irradiation optical system 30. The first light source unit 20 comprises a first light source 21 and a light source lens 22. A laser light source capable of emitting laser light in a predetermined wavelength region may, for example, be used as the first light source 21. The laser light emitted from the first light source 21 is shaped by a light source lens 22 so as to become parallel light, and is emitted from the first light source unit 20 as the first irradiation light La. The first light source 21 may be a laser light source that emits pulsed light with a pulse width of less than one picosecond (for example, a pulse width in the femtosecond range) (for example, a laser light source that emits a femtosecond laser). The first light source 21 is not limited to a laser light source that emits pulsed light, and may be a laser light source that emits continuous-wave light. The first light source 21 is not limited to a laser light source, and may use a light-emitting diode (LED), a bright line lamp, or the like.

A wavelength of the first irradiation light La is selected from a wavelength region in which a substance constituting the substrate WF1 can be caused to emit light through multiphoton excitation (for example, a wavelength region of 700 nm to 1030 nm). For example, the wavelength of the first irradiation light La may be selected as a wavelength at which the substance constituting the substrate WF1 can be caused to emit light through two-photon excitation. When the substrate WF1 is a GaN substrate, the wavelength of the first irradiation light La may be selected as 700 nm or may be selected as 1030 nm. Two-photon excitation of GaN using laser light having a wavelength of 700 nm is disclosed in the literature "Tomoyuki Tanikawa et al., Three-dimensional imaging of threading dislocations in GaN crystals using two-photon excitation photoluminescence, Applied Physics Express, 11, 031004 (2018)". Multiphoton excitation of GaN using laser light having a wavelength of 1030 nm is disclosed in the literature "Mayuko Tsukakoshi et al., Identification of Burgers vectors of threading dislocations in freestanding GaN substrates via multiphoton-excitation photoluminescence mapping, Applied Physics Express, 14, 055504 (2021)".

The first irradiation optical system 30 directs the first irradiation light La emitted from the first light source unit 20 toward the substrate WF1. The first irradiation optical system 30 comprises, in order from the first light source unit 20, a numerical aperture setting member 39, the deflection scanning section 31, a first relay lens 32, a second relay lens 33, a first dichroic mirror 34, a second dichroic mirror 35, and the objective optical system 36. The objective optical system 36 is disposed above the stage 11. The objective optical system 36 is opposite the substrate WF1 supported by the stage 11. The objective optical system 36 comprises a plurality of lenses 37 and is accommodated in a lens barrel 38.

The objective optical system 36 collects the first irradiation light La from the second dichroic mirror 35 (the first light source unit 20). By moving the stage 11 in the Z direction with the stage moving part 12, the relative position of the objective optical system 36 with respect to the substrate WF1 supported by the stage 11 is adjusted such that the first irradiation light La emitted from the objective optical system 36 is collected inside the substrate WF1. In other words, a positional relationship between the stage 11 and the focal position of the first irradiation optical system 30, and consequently a positional relationship between the substrate WF1 and the focal position of the first irradiation optical system 30, is changed. Hereinafter, **a region inside the substrate WF1 in which the first irradiation** light La is collected to become a size approximately a resolution limit of the objective optical system 36 may be referred to as an irradiation region 25. Note that a size (a diameter) of the irradiation region 25 is, for example, a beam diameter of the first irradiation light La being a laser beam (for example, $1/e^2$ diameter). The resolution limit of the objective optical system 36 corresponds to a radius of a so-called first dark ring of an Airy disk. When the size (the diameter) of the irradiation region 25 is smaller than a diameter of the first dark ring of the Airy disk, the first irradiation light La is said to be collected to become the resolution limit.

Note that in FIG. 1, the objective optical system 36 comprises four lenses 37 as an example but is not limited thereto. For example, the objective optical system 36 may comprise five or more lenses, or may comprise two or three lenses. At least part of the plurality of lenses 37 may be movable in the optical axis direction of the objective optical system 36 by rotating a correction ring (not shown) provided in the lens barrel 38. Note that instead of moving the stage 11 in the Z direction with the stage moving part 12 or in addition to moving the stage 11 in the Z direction with the stage moving part 12, the objective optical system 36 may be moved in the Z direction (optical axis direction) by a distance changing apparatus (not shown) to change the focal position of the first irradiation optical system 30 inside the substrate WF1 in the Z direction.

Note that one or more optical members among the optical members constituting the first irradiation optical system 30 may be moved to change the focal position of the first irradiation optical system 30 in the Z direction, or one or more optical members among the optical members constituting the first irradiation optical system 30 may be moved as variable-focal-length optical elements to change the focal position of the first irradiation optical system 30 in the Z direction. At this time, a moving mechanism that moves the one or more optical members may be referred to as a distance changing apparatus, and the variable-focal-length optical elements may be referred to as distance changing apparatuses. The stage moving part 12 may also be referred to as a distance changing apparatus that changes a distance in the Z direction (optical axis direction of the first irradiation optical system 30) between the substrate WF1 and the light collection position of the first irradiation light La.

The deflection scanning section 31 scans the inside of the substrate WF1 with the first irradiation light La from the first light source unit 20 in two directions, namely the X direction and the Y direction. An X direction deflection mirror 31a and a Y direction deflection mirror 31b that can change a propagation direction of the first irradiation light La are provided in the deflection scanning section 31. The X direction deflection mirror 31a and the Y direction deflection mirror 31b are implemented using galvanometer mirrors, MEMS mirrors, resonant mirrors (resonancetype mirrors), or the like. The X direction deflection mirror 31a and the Y direction deflection mirror 31b are disposed at a position of a plane conjugate to a pupil plane Pp of the objective optical system 36 or in a vicinity of the position of the plane conjugate to the pupil plane Pp of the objective optical system 36. Hereinafter, the plane conjugate to the pupil plane Pp of the objective optical system 36 may be referred to as a pupil-conjugate plane.

By the X direction deflection mirror 31a swinging or rotating in a rotational direction centered on a Y axis (a $\theta y$ direction), the propagation direction of the first irradiation light La changes in the $\theta y$ direction about the Y axis and the irradiation region 25 in the substrate WF1 moves in the X direction. By the Y direction deflection mirror 31b swinging or rotating in a rotational direction centered on an X axis (a $\theta x$ direction), the propagation direction of the first irradiation light La changes in the $\theta x$ direction about the X axis and the irradiation region 25 in the substrate WF1 moves in the Y direction. Therefore, the deflection scanning section 31 can move the irradiation region 25 in the substrate WF1 in the two directions, namely the X direction and the Y direction (an XY direction), and two-dimensionally scan the inside of the substrate WF1, by causing the X direction deflection mirror 31a and the Y direction deflection mirror 31b to swing or rotate.

An intermediate image plane Im conjugate to the substrate WF1 (an object surface) is formed between the first relay lens 32 and the second relay lens 33. The first relay lens 32 collects the first irradiation light La from the deflection scanning section 31 onto the intermediate image plane Im. The second relay lens 33 converts the first irradiation light La from the first relay lens 32 into parallel light and guides the parallel light to the objective optical system 36 (the first dichroic mirror 34). Note that the first relay lens 32 and the second relay lens 33 are not limited to each being a single lens and may be implemented using a plurality of lenses. The first relay lens 32 may also be referred to as a scan lens. The second relay lens 33 may also be referred to as an image forming lens or a second objective lens.

The first dichroic mirror 34 may, for example, have a characteristic such that light in a blue light wavelength region or a wavelength region shorter than that of blue light is reflected, and light in a wavelength region longer than that of blue light is transmitted. The first dichroic mirror 34 is not limited to the above-described wavelength characteristic, and may have a characteristic such that light produced inside the substrate WF1 through multiphoton excitation is reflected, and the first irradiation light La from the first light source unit 20 passing through the second relay lens 33 is transmitted. Hereinafter, the light produced inside the substrate WF1 through multiphoton excitation may be referred to as detection light Ld.

The second dichroic mirror 35 may, for example, have a characteristic such that light in a green light wavelength region is reflected, and light in a wavelength region longer than that of green light and light in a wavelength region shorter than that of green light is transmitted. The second dichroic mirror 35 is not limited to the above-described wavelength characteristic, and may have a characteristic such that second irradiation light Lb from the surface detection unit 55 (and reflected light Le described below) is reflected, and the first irradiation light La from the first dichroic mirror 34 and the detection light Ld from the objective optical system 36 is transmitted.

The numerical aperture setting member 39 is implemented using, for example, a zoom-type beam expander. The numerical aperture setting member 39 sets an opening angle of the first irradiation light La collected inside the substrate WF1 by the first irradiation optical system 30, by changing the beam diameter of the first irradiation light La emitted from the first light source unit 20. The opening angle of the first irradiation light La is a maximum angle, with respect to the optical axis AX of the objective optical system 36, of the first irradiation light La collected by the first irradiation optical system 30 (the objective optical system 36). Note that a sine of the opening angle of the first irradiation light La multiplied by a refractive index of a medium between the substrate WF1 and the first irradiation optical system 30 may be referred to as an illumination numerical aperture of the first irradiation light La. In other words, the numerical aperture setting member 39 may set the illumination numerical aperture of the first irradiation light La collected inside the substrate WF1 by the first irradiation optical system 30, by changing the beam diameter of the first irradiation light La emitted from the first light source unit 20.

The illumination numerical aperture of the first irradiation light La (the sine of the opening angle of the first irradiation light La multiplied by the refractive index of the medium between the substrate WF1 and the first irradiation optical system 30) can be expressed as the following expression (A) in accordance with the beam diameter of the first irradiation light La at the pupil plane Pp of the objective optical system 36:

$$NAi = nim \times Da/2f \quad (A)$$

where NAi: the illumination numerical aperture of the first irradiation light La;

nim: the refractive index of the medium between the substrate WF1 and the first irradiation optical system 30;
Da: the beam diameter of the first irradiation light La at the pupil plane Pp of the objective optical system 36; and
f: a focal length of the objective optical system 36.

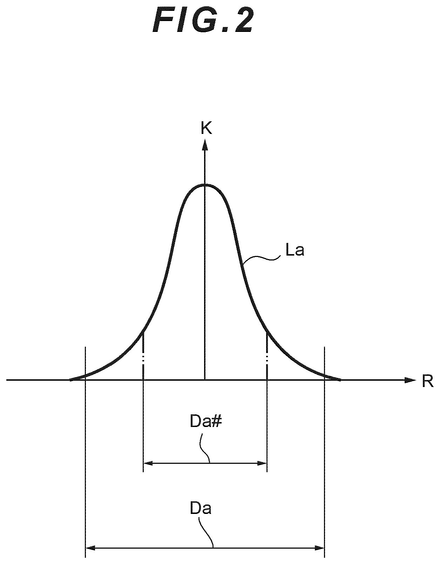

FIG. 2 is a graph for describing the beam diameter of the first irradiation light La. A horizontal axis of the graph shown in FIG. 2 indicates a radial position R of the first irradiation light La. A vertical axis of the graph shown in FIG. 2 indicates a beam intensity K of the first irradiation light La. As shown in FIG. 2, when the first irradiation light La is a Gaussian beam, a beam diameter Da of the first irradiation light La at the pupil plane Pp of the objective optical system 36 is defined as "a diameter at which the beam intensity is equal to or less than $1/e^2$ of a peak intensity", when the beam intensity K of the first irradiation light La is averaged in a circumferential direction. Note that as indicated by a dash-double-dot line in FIG. 2, even when an outer peripheral portion of the first irradiation light La is clipped before the beam intensity decreases to $1/e^2$ of the peak intensity, the beam intensity K of the first irradiation light La at a clipped position (position at which the beam intensity K drops to zero) decreases to $1/e^2$ or less of the peak intensity. Therefore, a beam diameter Da# of the first irradiation light La when the outer peripheral portion is clipped, including when the first irradiation light La is a tophat beam, is "the diameter at which the beam intensity is equal to or less than $1/e^2$ of the peak intensity".

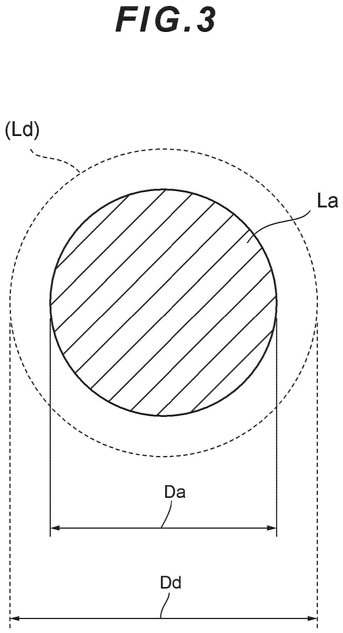

A sine of an opening angle of the detection light Ld is determined in accordance with an aperture diameter Dd (see FIG. 3) at the pupil plane Pp of the objective optical system 36. The opening angle of the detection light Ld is a maximum angle, with respect to the optical axis AX of the objective optical system 36, of the detection light Ld received by the first light reception section 40 (the objective optical system 36). The sine of the opening angle of the detection light Ld multiplied by the refractive index of the medium between the substrate WF1 and the first irradiation optical system 30 may be referred to as a detection numerical aperture of the detection light Ld or may be referred to as a numerical aperture of the objective optical system 36. The detection numerical aperture of the detection light Ld (the sine of the opening angle of the detection light Ld multiplied by the refractive index of the medium between the substrate WF1 and the first irradiation optical system 30) can be expressed as the following expression (B) in accordance with the aperture diameter Dd at the pupil plane Pp of the objective optical system 36:

$$NAd = nim \times Dd/2f \quad (B)$$

where NAd: the detection numerical aperture of the detection light Ld;

nim: the refractive index of the medium between the substrate WF1 and the first irradiation optical system 30;
Da: the beam diameter of the first irradiation light La at the pupil plane Pp of the objective optical system 36; and
f: the focal length of the objective optical system 36.

A ratio of the illumination numerical aperture of the first irradiation light La to the detection numerical aperture of the detection light Ld is defined as σ. The illumination numerical aperture of the first irradiation light La may be smaller than the detection numerical aperture of the detection light Ld. That is, σ may be less than 1. In other words, the beam diameter Da of the first irradiation light La at the pupil plane Pp of the objective optical system 36 may be smaller than the aperture diameter Dd at the pupil plane Pp of the objective optical system 36. Accordingly, the detection light Ld produced inside the substrate WF1 through multiphoton excitation can be received in a larger amount by the first light reception section 40 (the objective optical system 36). Note that, σ may be equal to 0.9, σ may be equal to 0.80, or σ may be equal to 0.70.

Returning to FIG. 1, the first light reception section 40 comprises a first receiving optical system 41 and a first detector 51. The first receiving optical system 41 receives the detection light Ld produced inside the substrate WF1 (the irradiation region 25) through multiphoton excitation caused by the first irradiation light La. The first receiving optical system 41 comprises the objective optical system 36, the second dichroic mirror 35, and the first dichroic mirror 34 of the first irradiation optical system 30. The first receiving optical system 41 further comprises, in order from the first dichroic mirror 34 (the substrate WF1), third relay lenses 42 and a barrier filter 43.

The third relay lenses 42 guide the detection light Ld reflected by the first dichroic mirror 34 to the pupil-conjugate plane of the objective optical system 36. Note that the third relay lenses 42 are not limited to being two lenses and may be implemented using three or more lenses. The barrier filter 43 has a characteristic such that light in a predetermined wavelength region (specifically, the detection light Ld) among the light from the first dichroic mirror 34 (the third relay lens 42) is transmitted. The barrier filter 43 blocks, for example, at least part of the first irradiation light La reflected by the substrate WF1, external light, stray light, and the like. Note that the barrier filter 43 is also referred to as a band-pass filter.

The first detector 51 is implemented using, for example, a photomultiplier tube, a photodiode, or an avalanche photodiode. A detection surface 52 disposed at or in a vicinity of the pupil-conjugate surface of the objective optical system 36 is provided on the first detector 51. The first detector 51 receives the light (the detection light Ld) emitted from the irradiation region 25 inside the substrate WF1, passing through the third relay lens 42 and the barrier filter 43 of the first receiving optical system 41, and incident on the detection surface 52; performs photoelectric conversion; and outputs a light reception signal (also referred to as a detection signal) of the irradiation region 25 inside the substrate WF1. Hereinafter, the light reception signal output from the first detector 51 may be referred to as a first light reception signal.

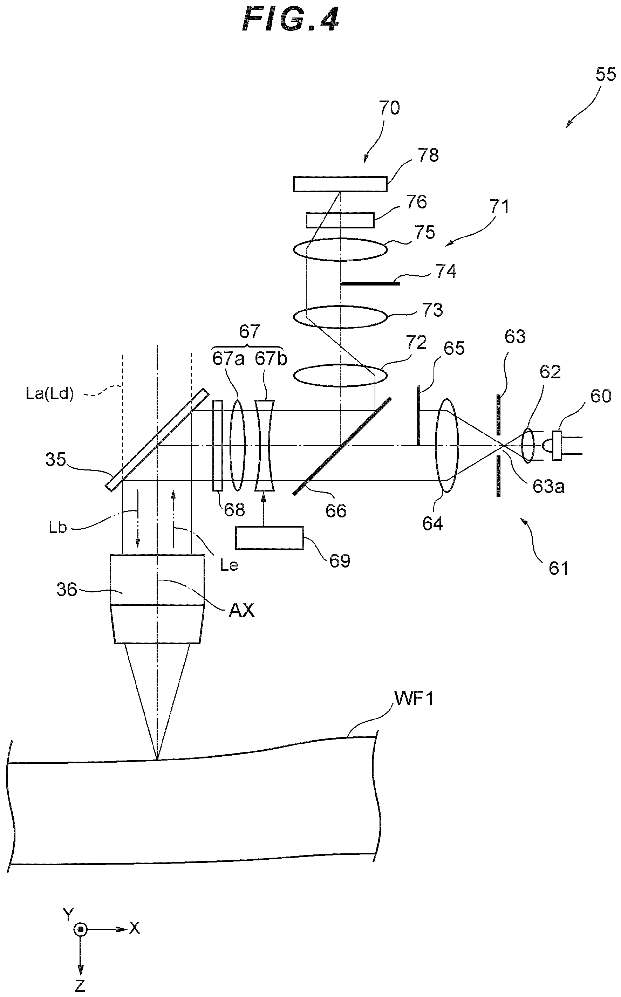

As illustrated in Fig. 4, the surface detection unit 55 comprises a second light source 60, a second irradiation optical system 61, and a second light reception section 70. The surface detection unit 55 further comprises the second dichroic mirror 35 of the first irradiation optical system 30 and the objective optical system 36. Note that the defect inspection apparatus 1 (the inspection optical apparatus 10) need not comprise the surface detection unit 55. The second light source 60 emits the second irradiation light Lb toward the second irradiation optical system 61. The second light source 60 is implemented using, for example, an LED. The second light source 60 is not limited to an LED, and may be implemented as a laser light source. A wavelength of the second irradiation light Lb is selected from a wavelength region that can be reflected by the second dichroic mirror 35 (for example, the green light wavelength region). The wavelength of the second irradiation light Lb may be selected from a wavelength region that can be reflected on a surface of the substrate WF1, or may be selected from a wavelength region that can be reflected on interfaces of a plurality of layers of the substrate WF1.

The second irradiation optical system 61 directs the second irradiation light Lb emitted from the second light source 60 toward the surface of the substrate WF1. At this time, the second irradiation optical system 61 directs the second irradiation light Lb toward the surface of the substrate WF1 from a direction inclined with respect to the optical axis AX of the objective optical system 36. The second irradiation optical system 61 comprises, in order from the second light source 60, a first collector lens 62, a slit plate 63, a second collector lens 64, a first pupil restriction mask 65, a half mirror 66, a focal position adjustment lens 67, and a band-pass filter 68.

The first collector lens 62 collects the second irradiation light Lb emitted from the second light source 60. The slit plate 63 is disposed at a position conjugate to the substrate WF1 (the object surface) . A slit aperture 63a is formed in a central portion of the slit plate 63. The slit aperture 63a is formed in a rectangular shape so that a longitudinal direction extends in the Y direction (a direction perpendicular to an optical axis direction of the second irradiation optical system 61). Note that the second irradiation light Lb passing through the slit aperture 63a is light with a rectangular cross section. The second collector lens 64 guides the second irradiation light Lb passing through the slit aperture 63a to the first pupil restriction mask 65.

The first pupil restriction mask 65 is disposed at a position of a pupil in the second irradiation optical system 61 and blocks half of the pupil. The first pupil restriction mask 65 is disposed so as to block half of a region of a rectangular cross section of the second irradiation light Lb along a center line in a longitudinal direction. The half mirror 66 transmits part of the second irradiation light Lb passing through the first pupil restriction mask 65. The half mirror 66 reflects part of the second irradiation light Lb reflected on the surface of the substrate WF1 and transmitted through the focal position adjustment lens 67, toward a light-reception second objective lens 72 of the second light reception section 70 (a second receiving optical system 71). A ratio of transmittance to reflectance of the half mirror 66 is set to, for example, 1:1. Hereinafter, the second irradiation light Lb reflected on the surface of the substrate WF1 may be referred to as the reflected light Le.

The focal position adjustment lens 67 comprises a convex lens 67a and a concave lens 67b. One of the convex lens 67a and the concave lens 67b is fixed on an optical axis, and the other is movable along the optical axis. Both the convex lens 67a and the concave lens 67b may be movable along the optical axis. In the following description, the convex lens 67a is fixed on the optical axis and the concave lens 67b is movable along the optical axis. A lens moving part 69 is provided at the focal position adjustment lens 67. The lens moving part 69 comprises a focal position adjustment lens motor (not shown) that can drive the concave lens 67b of the focal position adjustment lens 67. The lens moving part 69 moves the concave lens 67b of the focal position adjustment lens 67 along the optical axis. Note that the convex lens 67a may be a lens group comprising a plurality of lenses that collectively have positive power, and the concave lens 67b may be a lens group comprising a plurality of lenses that collectively have negative power. In this case, the lens moving part 69 may move one or more of these lens groups along the optical axis.

Note that when a plurality of types of focal position adjustment lenses 67 with different magnifications are provided, the lens moving part 69 may comprise a focal position adjustment lens electric turret (not shown). In this case, the focal position adjustment lens electric turret of the lens moving part 69, for example, selects one of the plurality of types of the focal position adjustment lenses 67 in response to operation of a focal position switching operation switch (not shown) provided on the inspection optical apparatus 10 or the information processing apparatus 90, and disposes it on an optical path between the half mirror 66 and the band-pass filter 68.

The band-pass filter 68 is disposed on an optical path between the focal position adjustment lens 67 and the second dichroic mirror 35. For example, the band-pass filter 68 has a characteristic such that light in the green light wavelength region (specifically, the second irradiation light Lb and the reflected light Le) is transmitted. The band-pass filter 68 blocks, for example, at least part of the detection light Ld reflected by the second dichroic mirror 35, external light, stray light, and the like.

The second light reception section 70 comprises the second receiving optical system 71 and a second detector 78. The second receiving optical system 71 receives the reflected light Le from the surface of the substrate WF1 irradiated with the second irradiation light Lb, and collects the reflected light Le onto the second detector 78. The second receiving optical system 71 comprises the band-pass filter 68 of the second irradiation optical system 61, the focal position adjustment lens 67, and the half mirror 66. The second receiving optical system 71 further comprises, in order from the half mirror 66 (the substrate WF1), the light-reception second objective lens 72, a light-reception first relay lens 73, a second pupil restriction mask 74, a light-reception second relay lens 75, and a cylindrical lens 76.

The light-reception second objective lens 72 collects the reflected light Le reflected by the half mirror 66. The light-reception first relay lens 73 guides the reflected light Le from the light-reception second objective lens 72 to the second pupil restriction mask 74. The second pupil restriction mask 74 is disposed at a position of a pupil in the second receiving optical system 71 and blocks half of the pupil. A region blocked by the second pupil restriction mask 74 corresponds to the region blocked by the first pupil restriction mask 65. Accordingly, the reflected light Le from the light-reception first relay lens 73 can pass through the second pupil restriction mask 74. The light-reception second relay lens 75 collects the reflected light Le passing through the second pupil restriction mask 74 and directs the reflected light Le toward a detection surface 79 of the second detector 78. The cylindrical lens 76 compresses, in the longitudinal direction (the Y direction) of the rectangular cross section, the reflected light Le collected by the light-reception second relay lens 75, and forms an image of the slit aperture 63a on the detection surface 79 of the second detector 78.

The second detector 78 is implemented using, for example, a line sensor. The detection surface 79 comprising a plurality of detection pixels (not shown) arranged in a one-dimensional direction (for example, the X direction being a lateral direction of the image of the slit aperture 63a) is formed on the second detector 78. The reflected light Le from the second receiving optical system 71 (the second irradiation light Lb reflected on the surface of the substrate WF1) is collected and the image of the slit aperture 63a is formed on the detection surface 79 of the second detector 78. The second detector 78 receives the image of the slit aperture 63a formed on the detection surface 79, performs photoelectric conversion, and outputs a light reception signal (also referred to as a detection signal) of the image of the slit aperture 63a. Note that the second detector 78 may be implemented using a twodimensional image sensor. Hereinafter, the light reception signal output from the second detector 78 may be referred to as a second light reception signal.

The optical apparatus control section 80 is implemented using, for example, a CPU (central processing apparatus). The optical apparatus control section 80 comprises an interface part 81, a storage unit 85, a data acquisition unit 86, and an image processing unit 87. The optical apparatus control section 80 controls, based on a control program stored in the storage unit 85, operations of the stage moving part 12, the first light source unit 20 (the first light source 21), the deflection scanning section 31, the numerical aperture setting member 39, the surface detection unit 55 (the second light source 60 and the lens moving part 69), and the like.

The interface part 81 is electrically connected to one end side of the network cable NW. The other end side of the network cable NW is electrically connected to an interface part 91 of the information processing apparatus 90. Setting information about the light collection position of the first irradiation light La and information relating to a configuration of the substrate WF1 are input to the interface part 81 of the optical apparatus control section 80, the setting information and the information being transmitted from the interface part 91 of the information processing apparatus 90 via the network cable NW. The setting information about the light collection position of the first irradiation light La and the information relating to the configuration of the substrate WF1 input to the interface part 81 is stored in the storage unit 85. Hereinafter, the information relating to the configuration of the substrate WF1 may be referred to as substrate configuration information.

The light collection position of the first irradiation light La is the light collection position of the first irradiation light La offset in the Z direction (the optical axis direction of the objective optical system 36) with respect to the surface of the substrate WF1. The setting information about the light collection position of the first irradiation light La is set in accordance with a Z position of a cross-sectional portion at which inspection is performed inside the substrate WF1. The setting information about the light collection position of the first irradiation light La may comprise information relating to the wavelength of the first irradiation light La.

The substrate configuration information may comprise information relating to a plate thickness of the substrate WF1, information relating to the refractive index of the substrate WF1, and the like. Note that the refractive index of the substrate WF1 is a refractive index with respect to the wavelength of the first irradiation light La. When the first irradiation light La is light having a wavelength bandwidth, the refractive index of the substrate WF1 may be a refractive index with respect to a center wavelength of the first irradiation light La. In this case, the refractive index of the substrate WF1 may be a refractive index with respect to one or more wavelengths within the wavelength bandwidth of the first irradiation light La. The substrate configuration information may comprise information relating to the number of layers in the substrate WF1.

The substrate configuration information may comprise information relating to the refractive index of the medium between the substrate WF1 and the first irradiation optical system 30. The medium between the substrate WF1 and the first irradiation optical system 30 may be, for example, air, or may be a gas such as nitrogen gas, a **liquid** such as water or oil, or the like.

The data acquisition unit 86 acquires the first light reception signal output from the first detector 51. The optical apparatus control section 80 causes the data acquisition unit 86 to acquire the first light reception signal in synchronization with the scanning inside the substrate WF1 performed by causing the deflection scanning section 31 to move the irradiation region 25 in the two directions of the X and Y directions (the XY direction). The image processing unit 87 generates image data of a cross section in the XY direction (a direction perpendicular to a plate thickness direction of the substrate WF1) inside the substrate WF1, based on the first light reception signal output from the first detector 51 and acquired by the data acquisition unit 86.

The data acquisition unit 86 acquires the second light reception signal output from the second detector 78. The optical apparatus control section 80 performs autofocus control described below, based on the second light reception signal output from the second detector 78 and acquired by the data acquisition unit 86. A calculation unit 88 determines a control signal to be output to the stage moving part 12 in the autofocus control. The calculation unit 88 determines a control signal to be output to the numerical aperture setting member 39.

The information processing apparatus 90 is implemented using, for example, a personal computer (PC). The information processing apparatus 90 comprises the interface part 91, an input part 92, a display part 93, an input/output control unit 94, a storage unit 95, and a determination unit 96. The interface part 91 is electrically connected to the other end side of the network cable NW. The image data about the inside of the substrate WF1 is input to the interface part 91 of the information processing apparatus 90, the image data being transmitted from the interface part 81 of the inspection optical apparatus 10 (the optical apparatus control section 80) via the network cable NW. The image data about the inside of the substrate WF1 input to the interface part 91 is stored in the storage unit 95.

The input part 92 is an input interface that can be operated by a user. The input part 92 is implemented using, for example, at least one of a mouse, a keyboard, a touchpad, or a trackball. The input part 92 detects an operation by the user, and outputs a detection result to the input/output control unit 94 as input information input by the user. The above-described setting information about the light collection position of the first irradiation light La may be input to the input part 92, or the above-described substrate configuration information may be input.

The display part 93 is implemented using, for example, a liquid-crystal display. The input/output control unit 94 displays, on the display part 93, a graphical user interface (GUI) necessary for operating the inspection optical apparatus 10, an image of the inside of the substrate WF1 transmitted from the inspection optical apparatus 10 (the optical apparatus control section 80), a result of determining whether a defect is present inside the substrate WF1 from the determination unit 96, and the like. The input/output control unit 94 transmits, for example, the setting information about the light collection position of the first irradiation light La and the substrate configuration information to the optical apparatus control section 80 of the inspection optical apparatus 10 via the interface part 91, the setting information and the substrate configuration information being input from the input part 92.

The determination unit 96 determines whether a defect is present inside the substrate WF1, based on the image data about the inside of the substrate WF1 stored in the storage unit 95. Note that when a defect (for example, a crystal defect) is present inside the substrate WF1, a defective portion is darker in the image of the inside of the substrate WF1, since multiphoton excitation caused by the irradiation with the first irradiation light La is less likely to occur at the defect portion inside the substrate WF1. Therefore, the determination unit 96 may determine whether a defect is present inside the substrate WF1, by setting a portion with a luminance value (intensity value) lower than a predetermined threshold value as the defect portion in the image inside the substrate WF1. The result of determining whether a defect is present inside the substrate WF1 from the determination unit 96 is stored in the storage unit 95.

In the defect inspection apparatus 1 having the above configuration, the setting information about the light collection position of the first irradiation light La and the substrate configuration information transmitted from interface part 91 of the information processing apparatus 90 is input to the interface part 81 of the inspection optical apparatus 10 when performing the inspection of the substrate WF1. The input setting information about the light collection position of the first irradiation light La and the substrate configuration information are stored in the storage unit 85 of the optical apparatus control section 80. The optical apparatus control section 80 controls the lens moving part 69 of the surface detection unit 55 such that the first irradiation light La is collected at the light collection position inside the substrate WF1.

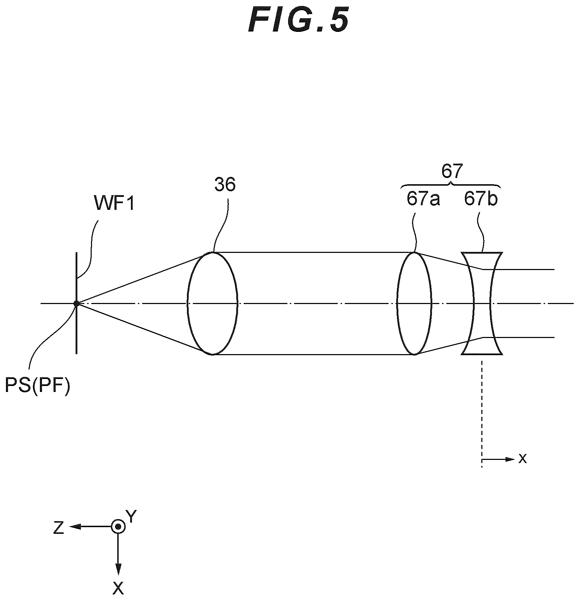

Here, an operation of the focal position adjustment lens 67 driven by the lens moving part 69 will be described with reference to FIGs. 5 to 7. Note that in FIGs. 5 to 7, only components necessary for the description are shown. As shown in FIG. 5, when the concave lens 67b of the focal position adjustment lens 67 is moved by the lens moving part 69 to a predetermined proximity position close to the convex lens 67a, an image forming position PS of the image of the slit aperture 63a of the second irradiation light Lb emitted from the objective optical system 36 coincides with a focal position PF of the objective optical system 36. In this case, the second irradiation light Lb becomes parallel light in front of and behind the focal position adjustment lens 67. In this state, the focal position PF of the objective optical system 36 is located on the surface of the substrate WF1, when the optical apparatus control section 80 performs the autofocus control described below.

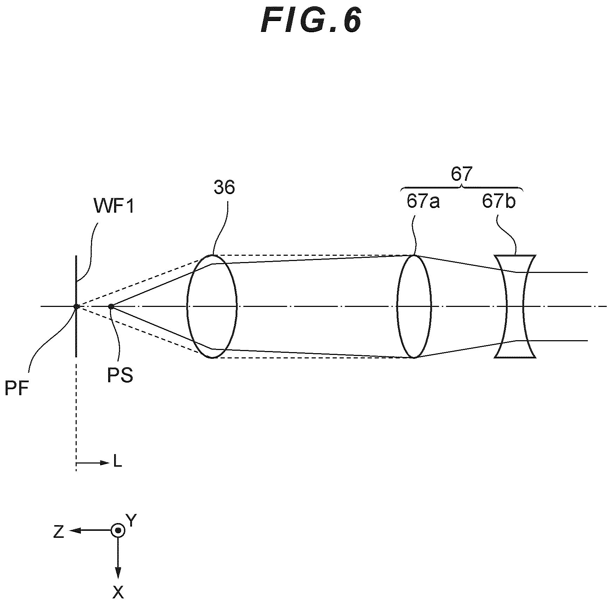

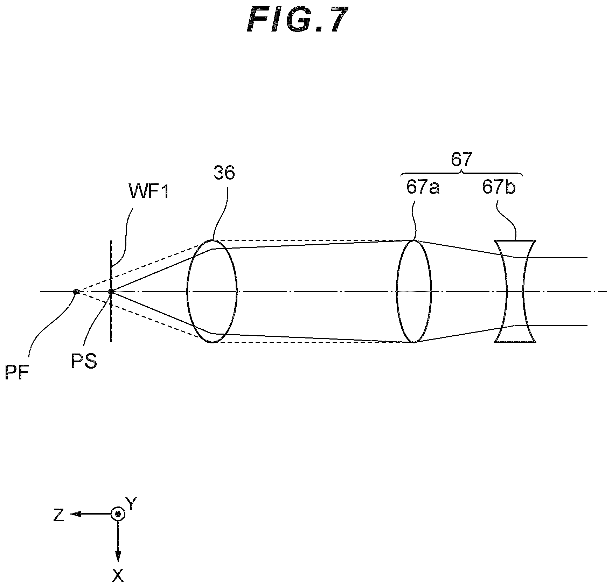

As shown in FIG. 6, when the concave lens 67b of the focal position adjustment lens 67 is moved by the lens moving part 69 by a movement distance x in a direction away from the convex lens 67a, the image forming position PS of the image of the slit aperture 63a of the second irradiation light Lb moves by a predetermined distance (also referred to as an offset amount L) from the focal position PF of the objective optical system 36 in a direction toward the objective optical system 36 (a -Z direction). In this state, the stage 11 is moved by the stage moving part 12 in the -Z direction, the surface of the substrate WF1 moves in the -Z direction, and as shown in FIG. 7, the image forming position PS of the image of the slit aperture 63a of the second irradiation light Lb is located on the surface of the substrate WF1, when the optical apparatus control section 80 performs the autofocus control described below. Accordingly, the focal position PF of the objective optical system 36 is located inside the substrate WF1, and the first irradiation light La emitted from the objective optical system 36 can be collected inside the substrate WF1. Note that the image forming position PS of the image of the slit aperture 63a of the second irradiation light Lb emitted from the objective optical system 36 can also be said to be a light collection position of the second irradiation light Lb.

Autofocus Control

Next, the autofocus control by the optical apparatus control section 80 using the surface detection unit 55 will be described. As shown in FIG. 4, the second irradiation light Lb emitted from the second light source 60 of the surface detection unit 55 is incident on the second irradiation optical system 61. The second irradiation light Lb incident on the second irradiation optical system 61 is collected by the first collector lens 62 and passes through the slit aperture 63a of the slit plate 63. The second irradiation light Lb passing through the slit aperture 63a is transmitted through the second collector lens 64 and passes through the first pupil restriction mask 65. Part of the second irradiation light Lb passing through the first pupil restriction mask 65 is transmitted through the half mirror 66 and is incident on the focal position adjustment lens 67. The second irradiation light Lb transmitted through the focal position adjustment lens 67 passes through the band-pass filter 68 and is reflected by the second dichroic mirror 35. The second irradiation light Lb reflected by the second dichroic mirror 35 is directed toward the substrate WF1 by the objective optical system 36 and collected.

The second irradiation light Lb directed from the objective optical system 36 toward the substrate WF1 is reflected on the surface of the substrate WF1 and is again incident on the objective optical system 36. The reflected light Le (the second irradiation light Lb) from the surface of the substrate WF1 incident on the objective optical system 36 is transmitted through the objective optical system 36 and is reflected by the second dichroic mirror 35. The reflected light Le reflected by the second dichroic mirror 35 passes through the band-pass filter 68 and is incident on the focal position adjustment lens 67. Part of the reflected light Le transmitted through the focal position adjustment lens 67 is reflected by the half mirror 66. The reflected light Le reflected by the half mirror 66 is collected by the light-reception second objective lens 72 of the second receiving optical system 71. The reflected light Le collected by the light-reception second objective lens 72 is transmitted through the light-reception first relay lens 73 and passes through the second pupil restriction mask 74. The reflected light Le that passing through the second pupil restriction mask 74 is transmitted through the light-reception second relay lens 75 and the cylindrical lens 76. The reflected light Le transmitted through the cylindrical lens 76 is collected and reaches the detection surface 79 of the second detector 78. The second detector 78 receives the image of the slit aperture 63a formed on the detection surface 79, performs photoelectric conversion, and outputs the second light reception signal.

Note that when a Z position of the surface of the substrate WF1 changes, a reflection position of the second irradiation light Lb on the surface of the substrate WF1 changes since a spacing between the surface of the substrate WF1 and the objective optical system 36 changes. When the reflection position of the second irradiation light Lb on the surface of the substrate WF1 changes, a position of the image of the slit aperture 63a formed on the detection surface 79 of the second detector 78 changes in an extension direction of the detection surface 79 (the lateral direction of the image of the slit aperture 63a). Therefore, the image forming position of the image of the slit aperture 63a (the light collection position of the second irradiation light Lb) with respect to the surface of the substrate WF1 in the optical axis direction of the objective optical system 36 can be determined based on the second light reception signal output from the second detector 78.

The second light reception signal output from the second detector 78 is acquired by the data acquisition unit 86. The calculation unit 88 determines, based on the second light reception signal acquired by the data acquisition unit 86, the control signal for the autofocus control for controlling the stage moving part 12 such that the image forming position of the image of the slit aperture 63a (the light collection position of the second irradiation light Lb) is located on the surface of the substrate WF1. The optical apparatus control section 80 outputs the control signal for the autofocus control determined by the calculation unit 88 to the stage moving part 12, and controls the stage moving part 12. The calculation unit 88 may determine the control signal for the autofocus control, based on a result of scanning along the detection surface 79 for the second light reception signal output from each of the plurality of detection pixels (not shown) of the second detector 78, as disclosed in U.S. Patent No. 7071451.

When collecting the first irradiation light La inside the substrate WF1, aberration occurs in a layer located between the light collection position of the first irradiation light La and the surface of the substrate WF1. Hereinafter, the aberration occurring in the layer located between the light collection position of the first irradiation light La and the surface of the substrate WF1 may be referred to as index-mismatch aberration. As the distance in the Z direction (the optical axis direction of the first irradiation optical system 30) from the surface of the substrate WF1 to the light collection position of the first irradiation light La inside the substrate WF1 increases, the index-mismatch aberration increases. As a result, a component of the first irradiation light La having a large angle with respect to the optical axis AX of the objective optical system 36 is no longer collected, and utilization efficiency of the first irradiation light La decreases.

Thus, the numerical aperture setting member 39 of the first irradiation optical system 30 sets the illumination numerical aperture of the first irradiation light La to be smaller as the distance in the Z direction from the surface of the substrate WF1 to the light collection position of the first irradiation light La inside the substrate WF1 increases. For example, the numerical aperture setting member 39 sets the illumination numerical aperture of the first irradiation light La when the distance in the Z direction between the substrate WF1 and the light collection position of the first irradiation light La is a second distance longer than a first distance to be smaller than the illumination numerical aperture of the first irradiation light La when the distance in the Z direction between the substrate WF1 and the light collection position of the first irradiation light La is the first distance.

The numerical aperture setting member 39 may set the illumination numerical aperture of the first irradiation light La so as to collect the first irradiation light La at an illumination numerical aperture that satisfies the following conditional expression (1):

[Expression 4]

$$-0.05 < \frac{NAi}{nim} + 0.2552 \times \log_{10} \frac{nim \times z}{\lambda} - f(t) < 0.05 \quad \cdots (1)$$

where NAi: the illumination numerical aperture of the first irradiation light La;

nim: the refractive index of the medium between the substrate WF1 and the first irradiation optical system 30;
z: a position in the optical axis direction of a focal point of the first irradiation optical system 30 (the objective optical system 36), with the surface of the substrate WF1 opposite the first irradiation optical system 30 (the objective optical system 36) as a reference position;
$\lambda$: the wavelength of the first irradiation light La; and
f(t): a function of t, defined by the following expression when the refractive index of the substrate WF1 is nsa and t = nsa/nim.

$$f(t) = 1.068 - 0.006502t + 3.837\exp(-3.175t)$$

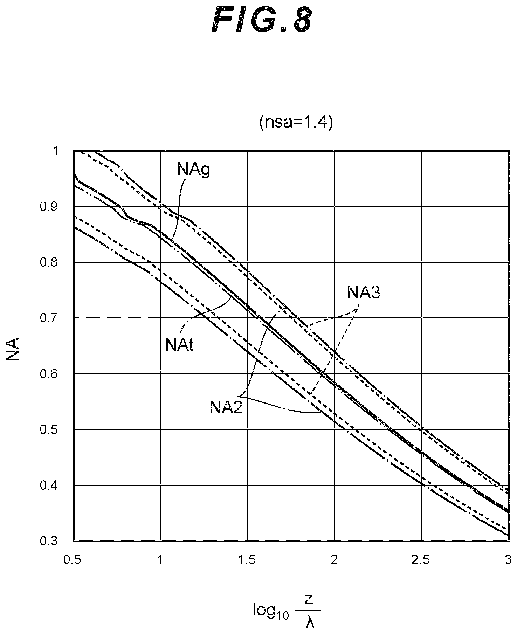

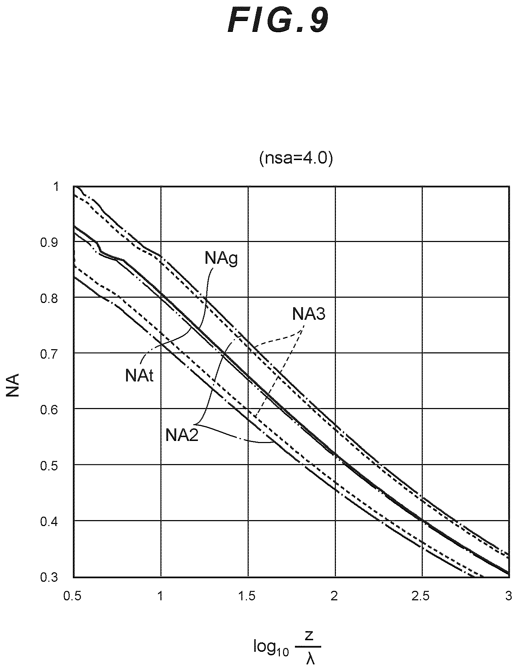

FIG. 8 shows a relationship between the light collection position and the numerical aperture of the first irradiation light La when the refractive index nsa of the substrate WF1 is 1.4. A horizontal axis of a graph shown in FIG. 8 indicates a logarithmic function of $z/\lambda$ with base 10. A vertical axis of the graph shown in FIG. 8 indicates a numerical aperture NA. FIG. 9 shows a relationship between the light collection position and the numerical aperture of the first irradiation light La when the refractive index nsa of the substrate WF1 is 4.0. Horizontal and vertical axes of a graph shown in FIG. 9 are the same as the horizontal and vertical axes of the graph shown in FIG. 8.

As can be seen from FIGs. 8 and 9, an optimal illumination numerical aperture NAg for when the first irradiation light La is a Gaussian beam decreases as the light collection position of the first irradiation light La moves away from the surface of the substrate WF1, in either case in which the refractive index nsa of the substrate WF1 is 1.4 and in which the refractive index nsa of the substrate WF1 is 4.0. The optimal illumination numerical aperture NAg for when the first irradiation light La is a tophat beam also decreases as the light collection position of the first irradiation light La moves away from the surface of the substrate WF1. In FIGs. 8 and 9, an effective range (upper limit and lower limit) of a numerical aperture NA2 in the case of two-photon excitation is indicated by a dash-dot line. An effective range (upper limit and lower limit) of a numerical aperture NA3 in the case of three-photon excitation is indicated by a dashed line.

Here, a function v is defined as in the following expression (2).

[Expression 5]

$$v = \frac{NAi}{nim} + 0.2552 \times \log_{10} \frac{nim \times z}{\lambda} - f(t) \quad \cdots (2)$$

When -0.05 < v < 0.05, expression (2) is the same as the above-described conditional expression (1).

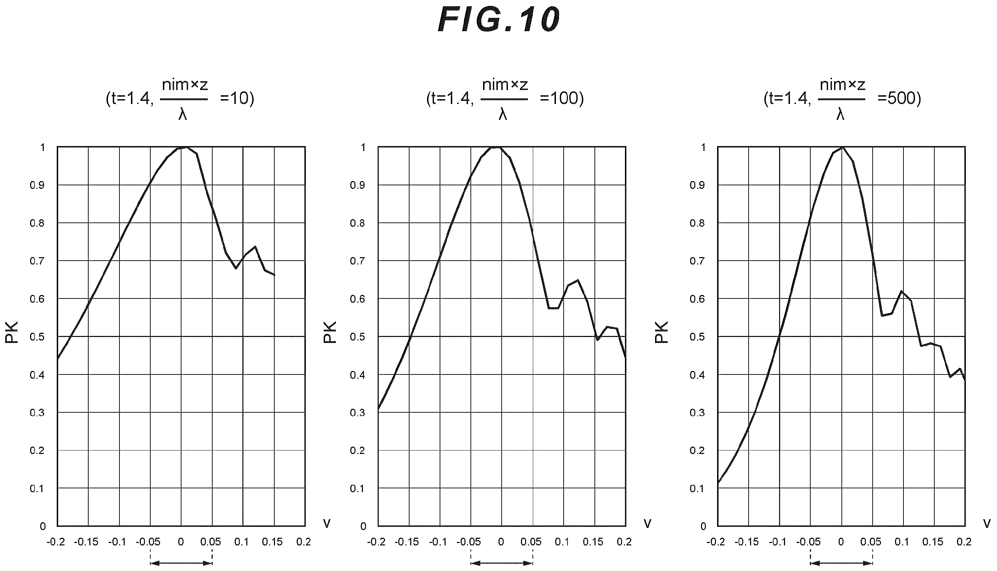

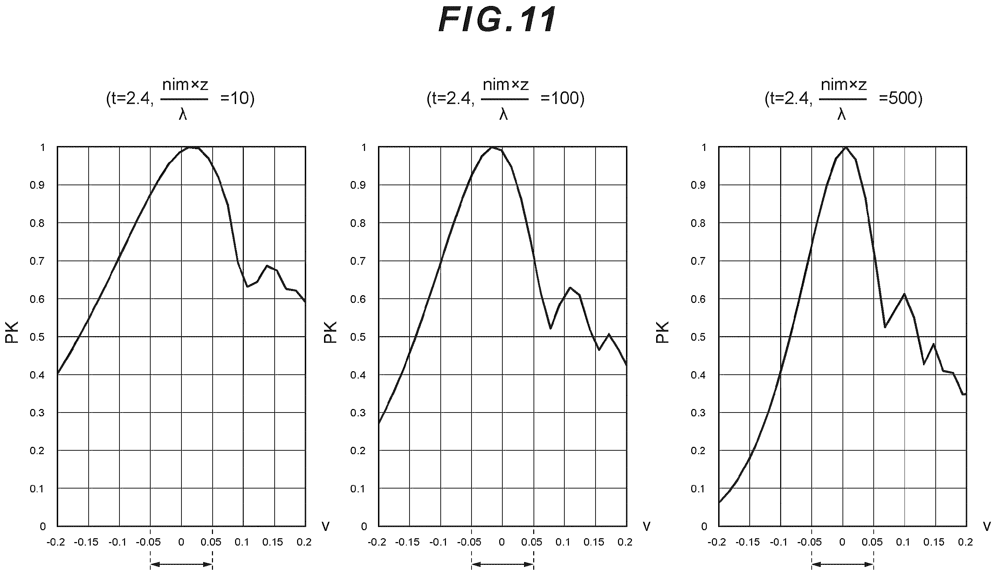

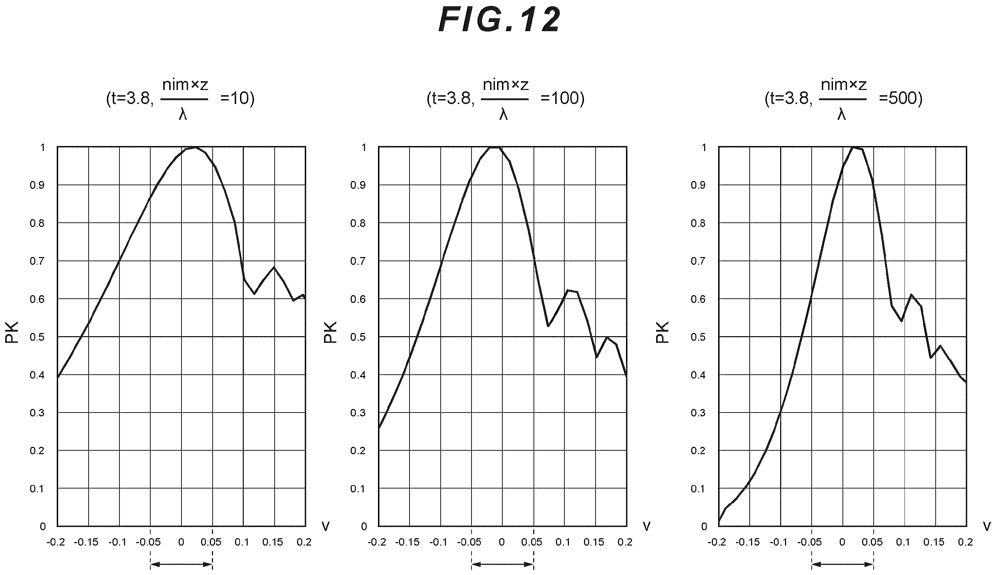

FIG. 10 compares and shows relationships between the function v and a peak intensity in a point spread function (PSF) when t = 1.4. Horizontal axes of graphs shown in FIG. 10 indicate a value of the function v. Vertical axes of the graphs shown in FIG. 10 each indicate the peak intensity in the point spread function (PSF) in the case of two-photon excitation, for when nim × z/λ = 10, nim × z/λ = 100, and nim × z/λ = 500. FIG. 11 compares and shows relationships between the function v and the peak intensity in a point spread function (PSF) when t = 2.4. Horizontal and vertical axes of graphs shown in FIG. 11 are the same as the horizontal and vertical axes of the graphs shown in FIG. 10. FIG. 12 compares and shows relationships between the function v and the peak intensity in a point spread function (PSF) when t = 3.8. Horizontal and vertical axes of graphs shown in FIG. 12 are the same as the horizontal and vertical axes of the graphs shown in FIG. 10.

As can be seen from FIGs. 10 to 12, even when the illumination numerical aperture NAi of the first irradiation light La is changed and the value of the function v is changed, the peak intensity of the point spread function (PSF) in the case of two-photon excitation remains at approximately 80% or higher of the optimal value in a range of -0.05 < v < 0.05. By satisfying the conditional expression (1), the peak intensity of the point spread function (PSF) in the case of multiphoton excitation can be increased, and the illumination numerical aperture of the first irradiation light La can be set to an appropriate range.

Inspection Method for Substrate

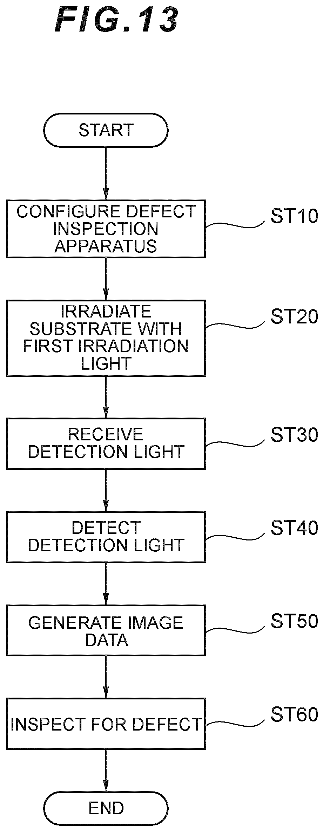

First, an inspection method for the substrate WF1 using the defect inspection apparatus 1 according to the first embodiment will be outlined. FIG. 13 is a flowchart showing the inspection method of the substrate WF1. As shown in FIG. 13, the defect inspection apparatus 1 is first configured based on the setting information of the light collection position of the first irradiation light La and the substrate configuration information stored in the storage unit 85 (step ST10). At this time, the calculation unit 88 determines the control signal for controlling the numerical aperture setting member 39 of the first irradiation optical system 30 so as to set the illumination numerical aperture of the first irradiation light La that satisfies the above-described conditional expression (1). The optical apparatus control section 80 outputs the control signal determined by the calculation unit 88 to the numerical aperture setting member 39, and controls the numerical aperture setting member 39. Under the control of the optical apparatus control section 80, the numerical aperture setting member 39 sets the illumination numerical aperture of the first irradiation light La so as to satisfy the above-described conditional expression (1). The numerical aperture setting member 39 sets the illumination numerical aperture of the first irradiation light La to be smaller as the distance in the Z direction from the surface of the substrate WF1 to the light collection position of the first irradiation light La inside the substrate WF1 increases.

At this time, the calculation unit 88 determines the offset amount L of the light collection position of the second irradiation light Lb with respect to the light collection position of the first irradiation light La. When determining the offset amount L, the calculation unit 88 may adjust the light collection position of the first irradiation light La so as to correct the index-mismatch aberration occurring in the substrate WF1. For example, the calculation unit 88 may determine the offset amount L from the light collection position of the first irradiation light La set inside the substrate WF1 (a depth from the surface of the substrate WF1), based on a light collection position adjustment data table created in advance by optical simulation.

The optical apparatus control section 80 outputs, to the lens moving part 69 of the surface detection unit 55, a control signal for achieving the offset amount L determined by the calculation unit 88. The lens moving part 69 moves the concave lens 67b of the focal position adjustment lens 67 in response to the control signal output from the optical apparatus control section 80. Accordingly, the light collection position of the second irradiation light Lb emitted from the objective optical system 36 (the image forming position of the image of the slit aperture 63a of the second irradiation light Lb) moves by the offset amount L from the light collection position of the first irradiation light La emitted from the objective optical system 36. In this state, the optical apparatus control section 80 can align the light collection position of the first irradiation light La emitted from the objective optical system 36 with the light collection position of the first irradiation light La set inside the substrate WF1, by performing the autofocus control.

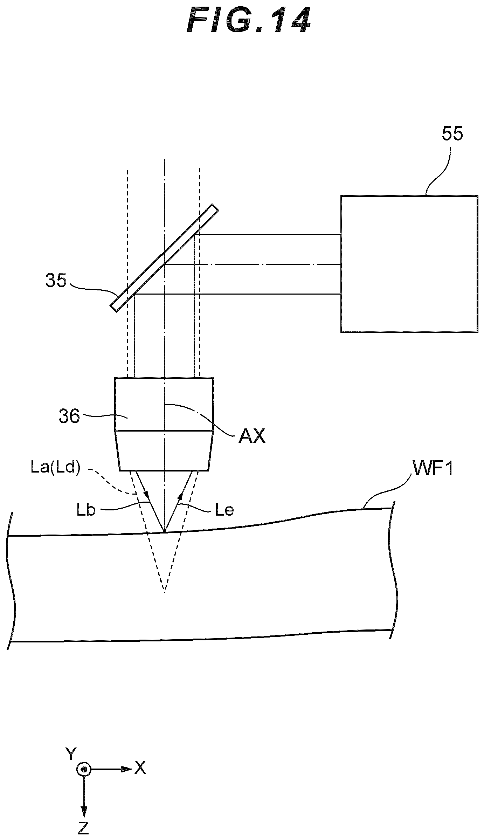

Next, the first irradiation light La is directed toward the substrate WF1 and the first irradiation light La is collected inside the substrate WF1 (step ST20). At this time, the laser light emitted from the first light source 21 of the first light source unit 20 is shaped by the light source lens 22 so as to become parallel light, and is emitted from the first light source unit 20 as the first irradiation light La. The first irradiation light La emitted from the first light source unit 20 passes through the numerical aperture setting member 39 of the first irradiation optical system 30 and is incident on the deflection scanning section 31. The first irradiation light La incident on the deflection scanning section 31 is reflected by the X direction deflection mirror 31a and the Y direction deflection mirror 31b in this order, and is incident on the first relay lens 32. The first irradiation light La transmitted through the first relay lens 32 is collected onto the intermediate image plane Im and is incident on the second relay lens 33. The first irradiation light La transmitted through the second relay lens 33 becomes parallel light and is transmitted through the first dichroic mirror 34. The first irradiation light La transmitted through the first dichroic mirror 34 is transmitted through the second dichroic mirror 35. As shown in FIG. 14, the first irradiation light La transmitted through the second dichroic mirror 35 is directed toward the substrate WF1 by the objective optical system 36 and is collected onto the light collection position set inside the substrate WF1.

When irradiating the substrate WF1 with the first irradiation light La, the deflection scanning section 31 of the first irradiation optical system 30 scans the inside of the substrate WF1 with the first irradiation light La from the first light source unit 20. After scanning the inside of the substrate WF1 in the observation region of the substrate WF1 opposite the objective optical system 36 with the deflection scanning section 31, the optical apparatus control section 80 outputs the control signal to the stage moving part 12 for moving the stage 11 in the X direction or the Y direction. By moving the stage 11 in the X direction or the Y direction with the stage moving part 12, the observation region of the substrate WF1 opposite the objective optical system 36 can be displaced in the X direction or the Y direction. Even if the observation region of the substrate WF1 is displaced in the X direction or the Y direction, the light collection position of the first irradiation light La in the optical axis direction of the first irradiation optical system 30 (the objective optical system 36) is maintained at the light collection position set inside the substrate WF1 under the autofocus control of the optical apparatus control section 80.

Next, the detection light Ld produced inside the substrate WF1 by the first irradiation light La with which the substrate WF1 is irradiated is received (step ST30). At this time, the detection light Ld produced inside the substrate WF1 (the irradiation region 25) through multiphoton excitation caused by the first irradiation light La is incident on the objective optical system 36. The detection light Ld from the substrate WF1 incident on the objective optical system 36 is transmitted through the objective optical system 36, becomes parallel light, and is transmitted through the second dichroic mirror 35. The detection light Ld transmitted through the second dichroic mirror 35 is reflected by the first dichroic mirror 34.

The detection light Ld reflected by the first dichroic mirror 34 passes through the third relay lens 42 and the barrier filter 43 of the first receiving optical system 41, and reaches the pupil-conjugate plane of the objective optical system 36 formed on an exit side of the third relay lens 42. The detection light Ld passing through the third relay lens 42 and the barrier filter 43 is incident on the detection surface 52 of the first detector 51 positioned at or in the vicinity of the pupil-conjugate plane of the objective optical system 36.

Next, the detection light Ld received by the first receiving optical system 41 is detected (step ST40). At this time, the first detector 51 performs photoelectric conversion on the detection light Ld incident on the detection surface 52 of the first detector 51 and outputs the first light reception signal. The first light reception signal output from the first detector 51 is acquired by the data acquisition unit 86.

Next, the image data inside the substrate WF1 is generated based on the detection signal (the first light reception signal) of the detection light Ld detected by the first detector 51 (step ST50) . At this time, the image processing unit 87 generates the image data of the cross section in the XY direction (the direction perpendicular to the plate thickness direction of the substrate WF1) inside the substrate WF1, based on the first light reception signal output from the first detector 51 and acquired by the data acquisition unit 86. The image data of the cross section in the XY direction inside the substrate WF1 generated by the image processing unit 87 is transmitted from the interface part 81 to the information processing apparatus 90.

The substrate WF1 is inspected for a defect, based on the image data generated by the image processing unit 87 (step ST60). At this time, the image data of the cross section in the XY direction inside the substrate WF1 is input to the interface part 91 of the information processing apparatus 90, the image data being transmitted from the interface part 81 of the inspection optical apparatus 10 (the optical apparatus control section 80). The image data of the cross section in the XY direction inside the substrate WF1 input to the interface part 91 is stored in the storage unit 95. The determination unit 96 determines whether a defect is present inside the substrate WF1, based on the image data of the cross section in the XY direction inside the substrate WF1 stored in the storage unit 95. The result of determining whether a defect is present inside the substrate WF1 from the determination unit 96 is stored in the storage unit 95.

Characteristic Configurations of First Embodiment

According to the first embodiment, the numerical aperture setting member 39 of the first irradiation optical system 30 sets the illumination numerical aperture of the first irradiation light La when the distance in the Z direction (the optical axis direction of the first irradiation optical system 30) between the substrate WF1 and the light collection position of the first irradiation light La is the second distance longer than the first distance to be smaller than the illumination numerical aperture of the first irradiation light La when the distance in the Z direction between the substrate WF1 and the light collection position of the first irradiation light La is the first distance. Accordingly, the light with which the substrate WF1 is irradiated (the first irradiation light La) can be effectively utilized, since the utilization efficiency of the first irradiation light La is increased by reducing the illumination numerical aperture of the first irradiation light La in accordance with a decrease in an effective NA.

The numerical aperture setting member 39 may set the illumination numerical aperture of the first irradiation light La so as to collect the first irradiation light La at an illumination numerical aperture that satisfies the above-described conditional expression (1). Accordingly, by satisfying the conditional expression (1), the peak intensity of the point spread function (PSF) can be increased, and the illumination numerical aperture of the first irradiation light La can be set to an appropriate range.

The numerical aperture setting member 39 may set the illumination numerical aperture of the first irradiation light La collected inside the substrate WF1 by the first irradiation optical system 30, by changing the beam diameter of the first irradiation light La. Accordingly, the configuration of the numerical aperture setting member 39 can be simplified.

The first receiving optical system 41 of the first light reception section 40 may receive the detection light Ld produced through multiphoton excitation inside the substrate WF1, and the illumination numerical aperture of the first irradiation light La may be smaller than the detection numerical aperture of the detection light Ld received by the first receiving optical system 41. Accordingly, the detection light Ld produced inside the substrate WF1 through multiphoton excitation can be received in a larger amount by the first receiving optical system 41 (the objective optical system 36).

The image processing unit 87 that generates the image data about the inside of the substrate WF1 based on the detection signal (the first light reception signal) from the first detector 51 may be provided. As described above, the image data about the inside of the substrate WF1 can be generated with high precision, by setting the illumination numerical aperture of the first irradiation light La to an appropriate range.

The determination unit 96 that determines whether a defect is present inside the substrate WF1 based on the image data about the inside of the substrate WF1 generated by the inspection optical apparatus 10 may be provided in the information processing apparatus 90. As described above, inspection accuracy of the defect inspection inside the substrate WF1 can be increased by setting the illumination numerical aperture of the first irradiation light La to an appropriate range. Note that the determination unit 96 may be provided in the optical apparatus control section 80 of the inspection optical apparatus 10.

Second Embodiment

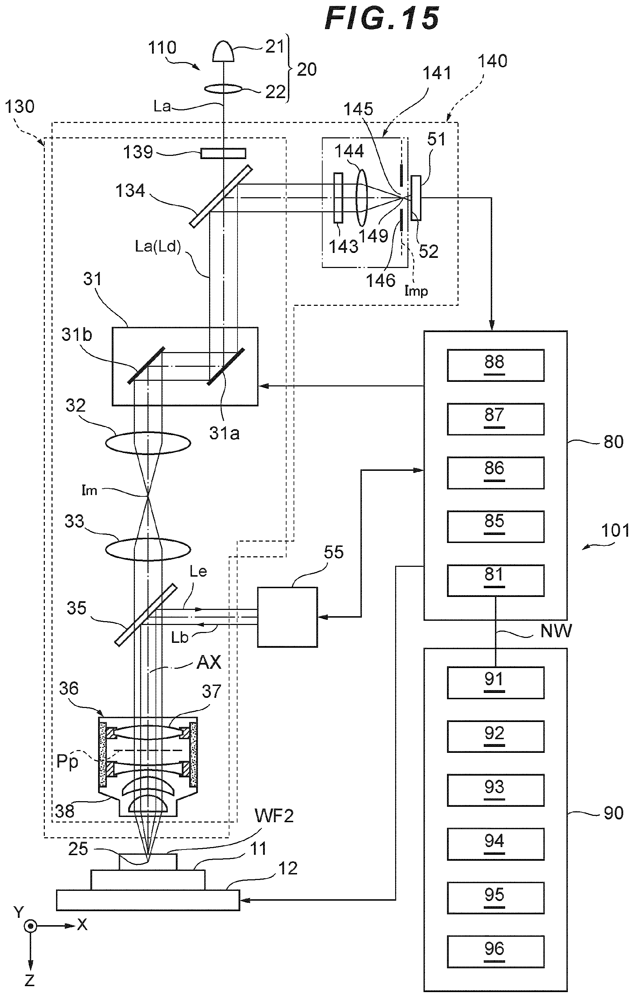

First, a defect inspection apparatus according to a second embodiment will be described. Essential parts of the defect inspection apparatus according to the second embodiment are common to those of the defect inspection apparatus 1 according to the first embodiment, except for the numerical aperture setting member and the first light reception section in the inspection optical apparatus. Therefore, constituent elements similar to those of the first embodiment will be denoted by the same reference numerals as in the first embodiment and detailed description thereof will be omitted. As shown in FIG. 15, a defect inspection apparatus 101 according to the second embodiment comprises an inspection optical apparatus 110 and an information processing apparatus 90. The inspection optical apparatus 110 and the information processing apparatus 90 can transmit and receive data to and from each other via a network cable NW. The inspection optical apparatus 110 comprises a stage 11 on which a substrate WF2 is placed, a first light source unit 20, a first irradiation optical system 130, a first light reception section 140, a surface detection unit 55, and an optical apparatus control section 80.

The stage 11 has a similar configuration to that of the stage 11 according to the first embodiment, and detailed description thereof will be omitted. In the second embodiment, the stage 11 supports the substrate WF2 being an inspection object. The substrate WF2 may comprise, for example, a layer made of SiC.

The first light source unit 20 has a similar configuration to that of the first light source unit 20 according to the first embodiment, and detailed description thereof will be omitted. In the second embodiment, the first light source unit 20 emits first irradiation light La toward the first irradiation optical system 130. A wavelength of the first irradiation light La is selected from a wavelength region in which a substance constituting the substrate WF2 can be caused to emit light through one-photon excitation.

The first irradiation optical system 130 directs the first irradiation light La emitted from the first light source unit 20 toward the substrate WF2. The first irradiation optical system 130 comprises, in order from the first light source unit 20, a numerical aperture setting member 139, a first dichroic mirror 134, a deflection scanning section 31, a first relay lens 32, a second relay lens 33, a second dichroic mirror 35, and an objective optical system 36. The first dichroic mirror 134 has a similar configuration as that of the first dichroic mirror 34 according to the first embodiment. In the second embodiment, the first dichroic mirror 134 may have a characteristic such that light produced inside the substrate WF2 through one-photon excitation is reflected, and the first irradiation light La from the first light source unit 20 passing through the numerical aperture setting member 139 is transmitted. Hereinafter, similar to the light produced inside the substrate WF1 through multiphoton excitation, the light produced inside the substrate WF2 through one-photon excitation may be referred to as detection light Ld.

The deflection scanning section 31, the first relay lens 32, the second relay lens 33, the second dichroic mirror 35, and the objective optical system 36 have similar configurations to those of the deflection scanning section 31, the first relay lens 32, the second relay lens 33, the second dichroic mirror 35, and the objective optical system 36 according to the first embodiment, and detailed description thereof will be omitted. In the second embodiment, the second relay lens 33 collects the detection light Ld from the objective optical system 36 (the second dichroic mirror 35) onto an intermediate image plane Im. The first relay lens 32 converts the detection light Ld from the second relay lens 33 into parallel light and guides the parallel light to the deflection scanning section 31. The second dichroic mirror 35 may have a characteristic such that second irradiation light Lb from the surface detection unit 55 (and reflected light Le) is reflected, and the first irradiation light La from the second relay lens 33 and the detection light Ld from the objective optical system 36 is transmitted.

The numerical aperture setting member 139 is implemented using, for example, a zoom-type beam expander. The numerical aperture setting member 139 sets an opening angle of the first irradiation light La collected inside the substrate WF2 by the first irradiation optical system 130, by changing a beam diameter of the first irradiation light La emitted from the first light source unit 20. In other words, the numerical aperture setting member 139 may set an illumination numerical aperture of the first irradiation light La collected inside the substrate WF2 by the first irradiation optical system 130, by changing the beam diameter of the first irradiation light La emitted from the first light source unit 20.

In the second embodiment, the illumination numerical aperture of the first irradiation light La may be equal to a detection numerical aperture of the detection light Ld. That is, $\sigma$ may be equal to 1. In other words, a beam diameter Da of the first irradiation light La may be equal to an aperture diameter Dd of the objective optical system 36. Accordingly, the detection light Ld produced inside the substrate WF2 through one-photon excitation can be collected in a larger amount at an image plane Imp by the first receiving optical system 141. Note that the illumination numerical aperture of the first irradiation light La may be roughly equal to the detection numerical aperture of the detection light Ld. In other words, $\sigma$ may be equal to 1 $\pm$ 0.5%, or $\sigma$ may be equal to 1 $\pm$ 1.0%.

The first light reception section 140 comprises the first receiving optical system 141 and a first detector 51. The first receiving optical system 141 receives the detection light Ld produced inside the substrate WF2 (an irradiation region 25) through one-photon excitation caused by the first irradiation light La, and forms an image 149 of the irradiation region 25 inside the substrate WF2 on the image plane Imp. The first receiving optical system 141 comprises the objective optical system 36, the second dichroic mirror 35, the second relay lens 33, the first relay lens 32, the deflection scanning section 31, and the first dichroic mirror 134 of the first irradiation optical system 130. The first receiving optical system 141 further comprises, in order from the first dichroic mirror 134 (the substrate WF2), a barrier filter 143, a collector lens 144, and a light shielding plate 146 including a pinhole 145 (an aperture).

The barrier filter 143 has a characteristic such that light in a predetermined wavelength region (specifically, the detection light Ld) among the light from the first dichroic mirror 134 is transmitted. The barrier filter 143 blocks, for example, at least part of the first irradiation light La reflected by the substrate WF2, external light, stray light, and the like. Note that the barrier filter 143 is also referred to as a band-pass filter. The collector lens 144 collects the detection light Ld transmitted through the barrier filter 143 onto the image plane Imp, and forms the image 149 of the irradiation region 25 inside the substrate WF2. Note that the substrate WF2 (an object surface), the intermediate image plane Im, and the image plane Imp are conjugate to each other. The collector lens 144 is not limited to being one lens and may be implemented as a plurality of lenses. A zoom optical system (not shown) that can change a size of the image 149 formed on the image plane Imp may be provided between the collector lens 144 and the image plane Imp.

The light shielding plate 146 is provided at a position in a vicinity of the image plane Imp. The light shielding plate 146 allows only the light (detection light Ld) collected onto the image plane Imp by the collector lens 144 to pass through the pinhole 145. Accordingly, among the light from the substrate WF2, only the detection light Ld produced at the light collection position of the first irradiation light La (the irradiation region 25) can pass through the pinhole 145. The first detector 51 has a similar configuration to that of the first detector 51 according to the first embodiment, and detailed description thereof will be omitted. In the second embodiment, a detection surface 52 of the first detector 51 is disposed at a position in a vicinity of the pinhole 145.

Note that a detector array comprising a plurality of detection pixels may be provided at the image plane Imp instead of the pinhole 145 and the first detector 51. For example, an avalanche photodiode array, a complementary metal-oxide-semiconductor (CMOS) sensor, a charge-coupled device (CCD) sensor, or the like may be used as the detector array. The detector array may receive the image 149 of the irradiation region 25 inside the substrate WF2 with the plurality of detection pixels, perform photoelectric conversion, and output a first light reception signal. An image processing unit 87 may generate image data about the inside of the substrate WF2, based on the first light reception signal output from a predetermined single one or more of the detection pixels in the detector array.

The surface detection unit 55 has a similar configuration to that of the surface detection unit 55 according to the first embodiment, and detailed description thereof will be omitted. In the second embodiment, a wavelength of the second irradiation light Lb is selected from a wavelength region that can be reflected by the second dichroic mirror 35 (for example, a green light wavelength region). The wavelength of the second irradiation light Lb may be selected from a wavelength region that can be reflected on a surface of the substrate WF2.

The optical apparatus control section 80 has a similar configuration to that of the optical apparatus control section 80 according to the first embodiment, and detailed description thereof will be omitted. In the second embodiment, the optical apparatus control section 80 controls, based on a control program stored in a storage unit 85, operations of a stage moving part 12, the first light source unit 20 (a first light source 21), the numerical aperture setting member 139, the deflection scanning section 31, the surface detection unit 55 (a second light source 60 and a lens moving part 69), and the like.

Inspection Method for Substrate

First, an inspection method for the substrate WF2 using the defect inspection apparatus 101 according to the second embodiment will be outlined. The inspection method for the substrate WF2 according to the second embodiment is similar to the inspection method for the substrate WF1 according to the first embodiment. Therefore, the inspection method will be described using the flowchart shown in FIG. 13, which is the same as for the first embodiment. The defect inspection apparatus 101 is first configured based on the setting information of the light collection position of the first irradiation light La and the substrate configuration information stored in the storage unit 85 (step ST10). At this time, the calculation unit 88 determines the control signal for controlling the numerical aperture setting member 139 of the first irradiation optical system 130 so as to set the illumination numerical aperture of the first irradiation light La that satisfies the above-described conditional expression (1). The optical apparatus control section 80 outputs the control signal determined by the calculation unit 88 to the numerical aperture setting member 139, and controls the numerical aperture setting member 139. Under the control of the optical apparatus control section 80, the numerical aperture setting member 139 sets the illumination numerical aperture of the first irradiation light La so as to satisfy the above-described conditional expression (1). The numerical aperture setting member 139 sets the illumination numerical aperture of the first irradiation light La to be smaller as the distance in the Z direction from the surface of the substrate WF2 to the light collection position of the first irradiation light La inside the substrate WF2 increases.

At this time, the calculation unit 88 determines the offset amount L of the light collection position of the second irradiation light Lb with respect to the light collection position of the first irradiation light La. When determining the offset amount L, the calculation unit 88 may adjust the light collection position of the first irradiation light La so as to correct the index-mismatch aberration occurring in the substrate WF2. For example, the calculation unit 88 may determine the offset amount L from the light collection position of the first irradiation light La set inside the substrate WF2 (a depth from the surface of the substrate WF2), based on a light collection position adjustment data table created in advance by optical simulation.

The optical apparatus control section 80 outputs, to the lens moving part 69 of the surface detection unit 55, a control signal for achieving the offset amount L determined by the calculation unit 88. The lens moving part 69 moves the concave lens 67b of the focal position adjustment lens 67 in response to the control signal output from the optical apparatus control section 80. Accordingly, the light collection position of the second irradiation light Lb emitted from the objective optical system 36 (the image forming position of the image of the slit aperture 63a of the second irradiation light Lb) moves by the offset amount L from the light collection position of the first irradiation light La emitted from the objective optical system 36. In this state, the optical apparatus control section 80 can align the light collection position of the first irradiation light La emitted from the objective optical system 36 with the light collection position of the first irradiation light La set inside the substrate WF2, by performing the autofocus control.

Next, the first irradiation light La is directed toward the substrate WF2 and the first irradiation light La is collected inside the substrate WF2 (step ST20). At this time, the laser light emitted from the first light source 21 of the first light source unit 20 is shaped by the light source lens 22 so as to become parallel light, and is emitted from the first light source unit 20 as the first irradiation light La. The first irradiation light La emitted from the first light source unit 20 passes through the numerical aperture setting member 139 of the first irradiation optical system 130 and is incident on the first dichroic mirror 134. The first irradiation light La incident on the first dichroic mirror 134 is transmitted through the first dichroic mirror 134, and is incident on the deflection scanning section 31. The first irradiation light La incident on the deflection scanning section 31 is reflected by the X direction deflection mirror 31a and the Y direction deflection mirror 31b in this order, and is incident on the first relay lens 32. The first irradiation light La transmitted through the first relay lens 32 is collected onto the intermediate image plane Im and is incident on the second relay lens 33. The first irradiation light La transmitted through the second relay lens 33 becomes parallel light and is transmitted through the second dichroic mirror 35. Similar to the first embodiment, the first irradiation light La transmitted through the second dichroic mirror 35 is directed toward the substrate WF2 by the objective optical system 36 and is collected onto the light collection position set inside the substrate WF2.

When irradiating the substrate WF2 with the first irradiation light La, the deflection scanning section 31 of the first irradiation optical system 130 scans the inside of the substrate WF2 with the first irradiation light La from the first light source unit 20. After scanning the inside of the substrate WF2 in the observation region of the substrate WF2 opposite the objective optical system 36 with the deflection scanning section 31, the optical apparatus control section 80 outputs the control signal to the stage moving part 12 for moving the stage 11 in the X direction or the Y direction. By moving the stage 11 in the X direction or the Y direction with the stage moving part 12, the observation region of the substrate WF2 opposite the objective optical system 36 can be displaced in the X direction or the Y direction. Even if the observation region of the substrate WF2 is displaced in the X direction or the Y direction, the light collection position of the first irradiation light La in the optical axis direction of the first irradiation optical system 130 (the objective optical system 36) is maintained at the light collection position set inside the substrate WF2 under the autofocus control of the optical apparatus control section 80.

Next, the detection light Ld produced inside the substrate WF2 by the first irradiation light La with which the substrate WF2 is irradiated is received (step ST30). At this time, the detection light Ld produced inside the substrate WF2 (the irradiation region 25) through one-photon excitation caused by the first irradiation light La is incident on the objective optical system 36. The detection light Ld from the substrate WF2 incident on the objective optical system 36 is transmitted through the objective optical system 36, becomes parallel light, and is transmitted through the second dichroic mirror 35. The detection light Ld transmitted through the second dichroic mirror 35 is incident on the second relay lens 33. The detection light Ld transmitted through the second relay lens 33 is collected onto the intermediate image plane Im and is incident on the first relay lens 32. The detection light Ld transmitted through the first relay lens 32 becomes parallel light and is transmitted through the deflection scanning section 31. The detection light Ld incident on the deflection scanning section 31 is reflected by the Y direction deflection mirror 31b and the X direction deflection mirror 31a in this order, and is incident on the first dichroic mirror 134.

The detection light Ld reflected by the first dichroic mirror 134 passes through the barrier filter 143 of the first receiving optical system 141, and is incident on the collector lens 144. The detection light Ld transmitted through the collector lens 144 is collected onto the image plane Imp located in a vicinity of the light shielding plate 146, and forms the image 149 of the irradiation region 25 inside the substrate WF2. Accordingly, among the light from the substrate WF2, only the detection light Ld produced at the light collection position of the first irradiation light La (the irradiation region 25) can pass through the pinhole 145 of the light shielding plate 146. The detection light Ld passing through the pinhole 145 of the light shielding plate 146 is incident on the detection surface 52 of the first detector 51.

Next, the detection light Ld received by the first receiving optical system 141 is detected (step ST40). At this time, the first detector 51 performs photoelectric conversion on the detection light Ld passing through the pinhole 145 of the light shielding plate 146, and outputs the first light reception signal. The first light reception signal output from the first detector 51 is acquired by the data acquisition unit 86.

Next, the image data inside the substrate WF2 is generated based on the detection signal (the first light reception signal) of the detection light Ld detected by the first detector 51 (step ST50). At this time, the image processing unit 87 generates image data of a cross section in the XY direction (a direction perpendicular to a plate thickness direction of the substrate WF1) inside the substrate WF2, based on the first light reception signal output from the first detector 51 and acquired by the data acquisition unit 86. The image data of the cross section in the XY direction inside the substrate WF2 generated by the image processing unit 87 is transmitted from the interface part 81 to the information processing apparatus 90.

The substrate WF2 is inspected for a defect, based on the image data generated by the image processing unit 87 (step ST60). At this time, the image data of the cross section in the XY direction inside the substrate WF2 is input to the interface part 91 of the information processing apparatus 90, the image data being transmitted from the interface part 81 of the inspection optical apparatus 110 (the optical apparatus control section 80). The image data of the cross section in the XY direction inside the substrate WF2 input to the interface part 91 is stored in the storage unit 95. The determination unit 96 determines whether a defect is present inside the substrate WF2, based on the image data of the cross section in the XY direction inside the substrate WF2 stored in the storage unit 95. The result of determining whether a defect is present inside the substrate WF2 from the determination unit 96 is stored in the storage unit 95.

Characteristic Configurations of Second Embodiment

According to the second embodiment, similar effects as those of the first embodiment can be obtained. In the second embodiment, the first receiving optical system 141 of the first light reception section 140 may receive the detection light Ld produced through one-photon excitation inside the substrate WF2, and the illumination numerical aperture of the first irradiation light La may be equal to the detection numerical aperture of the detection light Ld received by the first receiving optical system 141. Accordingly, the detection light Ld produced inside the substrate WF2 through one-photon excitation can be collected in a larger amount at the image plane Imp by the first receiving optical system 141.

In each of the above-described embodiments, the first light source unit 20 is detachably and interchangeably provided in the inspection optical apparatus, but is not limited thereto, and may be provided separately from the inspection optical apparatus.

In each of the above-described embodiments, the substrate configuration information, the setting information about the light collection position of the first irradiation light La, and the like is input to the interface part of the optical apparatus control section, but are not limited thereto. For example, a user-operable input part may be connected to the optical apparatus control section, and the substrate configuration information, the setting information about the light collection position of the first irradiation light La, and the like may be input to the input part. The input part may be implemented using, for example, at least one of a mouse, a keyboard, a touchpad, or a trackball.

At least some of configuration requirements of each of the above-described embodiments can be appropriately combined with at least some other configuration requirements of each of the above-described embodiments. Some of the configuration requirements of each of the above-described embodiments need not be used.

The present invention is not limited to the above-described embodiments, and can be appropriately modified within a scope not contradicting the gist or technical idea of the invention as can be read from the claims and the entire specification. An inspection optical apparatus, a defect inspection apparatus, an irradiation optical system, and an inspection method with such modifications are also included in the technical scope of the present invention.

EXPLANATION OF NUMERALS AND CHARACTERS

1 defect inspection apparatus (first embodiment)
10 inspection optical apparatus
11 stage
12 stage moving part
20 first light source unit
30 first irradiation optical system
39 numerical aperture setting member
40 first light reception section
41 first receiving optical system
51 first detector
80 optical apparatus control section
87 image processing unit
90 information processing apparatus
96 determination unit
101 defect inspection apparatus (second embodiment)
110 inspection optical apparatus
130 first irradiation optical system
139 numerical aperture setting member
140 first light reception section
141 first receiving optical system
WF1 substrate (first embodiment)
WF2 substrate (second embodiment)

**Claims**

1. An inspection optical apparatus used for inspecting a substrate, the inspection optical apparatus comprising:

   an irradiation optical system that directs irradiation light toward the substrate and collects the irradiation light inside the substrate;
   a receiving optical system that receives light produced inside the substrate by the irradiation light with which the substrate is irradiated; and
   a distance changing apparatus that changes, in an optical axis direction of the irradiation optical system, a distance between the substrate and a light collection position of the irradiation light, wherein
   the irradiation optical system comprises a numerical aperture setting member that sets a numerical aperture of the irradiation light when the distance is a second distance longer than a first distance to be smaller than a numerical aperture of the irradiation light when the distance is the first distance.

2. The inspection optical apparatus according to claim 1, wherein the numerical aperture setting member sets a numerical aperture to collect the irradiation light, the numerical aperture being set such that the following conditional expression is satisfied:

   **[Expression 1]**

   $$-0.05 < \frac{NAi}{nim} + 0.2552 \times \log_{10} \frac{nim \times z}{\lambda} - f(t) < 0.05$$

   where NAi: the numerical aperture;

   nim: a refractive index of a medium between the substrate and the irradiation optical system;

z: a position in the optical axis direction of a focal point of the irradiation optical system, with a surface of the substrate opposite the irradiation optical system as a reference position;

λ: a wavelength of the irradiation light; and

f(t): a function of t, defined by the following expression when a refractive index of the substrate is nsa and t = nsa/nim.

```
f(t) = 1.068 - 0.006502t + 3.837exp(-3.175t)
```

3. An inspection optical apparatus used for inspecting a substrate, the inspection optical apparatus comprising:

an irradiation optical system that directs irradiation light toward the substrate and collects the irradiation light inside the substrate; and

a receiving optical system that receives light produced inside the substrate by the irradiation light with which the substrate is irradiated, wherein

the irradiation optical system comprises a numerical aperture setting member that sets a numerical aperture to collect the irradiation light, the numerical aperture being set such that the following conditional expression is satisfied:

**[Expression 2]**

$$-0.05 < \frac{NAi}{nim} + 0.2552 \times \log_{10}\frac{nim \times z}{\lambda} - f(t) < 0.05$$

where NAi: the numerical aperture;

nim: a refractive index of a medium between the substrate and the irradiation optical system;

z: a position in an optical axis direction of a focal point of the irradiation optical system, with a surface of the substrate opposite the irradiation optical system as a reference position;

λ: a wavelength of the irradiation light; and

f(t): a function of t, defined by the following expression when a refractive index of the substrate is nsa and t = nsa/nim.

```
f(t) = 1.068 - 0.006502t + 3.837exp(-3.175t)
```

4. The inspection optical apparatus according to any one of claims 1 to 3, wherein

the irradiation light is a laser beam, and

the numerical aperture setting member sets the numerical aperture by changing a beam diameter of the irradiation light.

5. The inspection optical apparatus according to any one of claims 1 to 4, wherein

the receiving optical system receives light produced through multiphoton excitation inside the substrate caused by the irradiation light with which the substrate is irradiated, and

the numerical aperture of the irradiation light is smaller than a numerical aperture of the light received by the receiving optical system.

6. The inspection optical apparatus according to any one of claims 1 to 4, wherein

the receiving optical system receives light produced through one-photon excitation inside the substrate caused by the irradiation light with which the substrate is irradiated, and

the numerical aperture of the irradiation light is equal to a numerical aperture of the light received by the receiving optical system.

7. The inspection optical apparatus according to any one of claims 1 to 6, further comprising:

a detection part that detects the light received by the receiving optical system and outputs a detection signal; and
a processing unit that generates information about the inside of the substrate, based on the detection signal from the detection part.

8.  A defect inspection apparatus comprising:

    the inspection optical apparatus according to claim 7, wherein
    the substrate is inspected for a defect, based on the information about the inside of the substrate generated by the inspection optical apparatus.

9.  An irradiation optical system that directs irradiation light toward a substrate and collects the irradiation light inside the substrate, the irradiation optical system comprising:

    a numerical aperture setting member that sets a numerical aperture to collect the irradiation light, the numerical aperture being set such that the following conditional expression is satisfied:

    **[Expression 3]**

    $$-0.05 < \frac{NAi}{nim} + 0.2552 \times \log_{10} \frac{nim \times z}{\lambda} - f(t) < 0.05$$

    where NAi: the numerical aperture;

    nim: a refractive index of a medium between the substrate and the irradiation optical system;
    z: a position in an optical axis direction of a focal point of the irradiation optical system, with a surface of the substrate opposite the irradiation optical system as a reference position;
    $\lambda$: a wavelength of the irradiation light; and
    f(t): a function of t, defined by the following expression when a refractive index of the substrate is nsa and t = nsa/nim.

    $$f(t) = 1.068 - 0.006502t + 3.837\exp(-3.175t)$$

10. The irradiation optical system according to claim 9, wherein
    the numerical aperture setting member comprises a variable aperture stop provided at a pupil position or a pupil-conjugate position in the irradiation optical system.

11. An inspection method for a substrate, the inspection method comprising:

    directing irradiation light toward the substrate and collecting the irradiation light inside the substrate;
    receiving light produced inside the substrate by the irradiation light with which the substrate is irradiated; and
    changing, in an optical axis direction of the irradiation optical system, a distance between the substrate and a light collection position of the irradiation light, wherein
    when collecting the irradiation light, a numerical aperture of the irradiation light when the distance is a second distance longer than a first distance is set to be smaller than a numerical aperture of the irradiation light when the distance is the first distance.

12. An inspection method for a substrate, the inspection method comprising:

    directing irradiation light toward the substrate and collecting the irradiation light inside the substrate; and
    receiving light produced inside the substrate by the irradiation light with which the substrate is irradiated, wherein
    when collecting the irradiation light, a numerical aperture is set to collect the irradiation light, the numerical aperture being set such that the following conditional expression is satisfied:

**[Expression 4]**

$$-0.05 < \frac{NAi}{nim} + 0.2552 \times \log_{10} \frac{nim \times z}{\lambda} - f(t) < 0.05$$

where NAi: the numerical aperture;

nim: a refractive index of a medium between the substrate and the irradiation optical system;

z: a position in an optical axis direction of a focal point of the irradiation optical system, with a surface of the substrate opposite the irradiation optical system as a reference position;

$\lambda$: a wavelength of the irradiation light; and

f(t): a function of t, defined by the following expression when a refractive index of the substrate is nsa and t = nsa/nim.

**f(t) = 1.068 - 0.006502t + 3.837exp(-3.175t)**

# FIG.1

# FIG.2

# FIG.3

(Ld)

La

Da

Dd

# FIG.4

# FIG.5

# FIG.6

WF1    36    67
        67a    67b

PF    PS

L

Z ← ⊙ Y
↓
X

# FIG.7

# FIG.8

(nsa=1.4)

# FIG.9

(nsa=4.0)

# FIG.10

$(t=1.4, \dfrac{nim \times z}{\lambda} =10)$

$(t=1.4, \dfrac{nim \times z}{\lambda} =100)$

$(t=1.4, \dfrac{nim \times z}{\lambda} =500)$

EP 4 775 952 A1

FIG.11

FIG.12

# FIG.13

```
        ┌──────────────┐
        │    START     │
        └──────┬───────┘
               │
               ▼
    ┌─────────────────────┐
    │ CONFIGURE DEFECT    │        ST10
    │ INSPECTION          │
    │ APPARATUS           │
    └──────────┬──────────┘
               │
               ▼
    ┌─────────────────────┐
    │ IRRADIATE           │        ST20
    │ SUBSTRATE WITH      │
    │ FIRST IRRADIATION   │
    │ LIGHT               │
    └──────────┬──────────┘
               │
               ▼
    ┌─────────────────────┐
    │ RECEIVE             │        ST30
    │ DETECTION LIGHT     │
    └──────────┬──────────┘
               │
               ▼
    ┌─────────────────────┐
    │ DETECT              │        ST40
    │ DETECTION LIGHT     │
    └──────────┬──────────┘
               │
               ▼
    ┌─────────────────────┐
    │ GENERATE IMAGE      │        ST50
    │ DATA                │
    └──────────┬──────────┘
               │
               ▼
    ┌─────────────────────┐
    │ INSPECT FOR DEFECT  │        ST60
    └──────────┬──────────┘
               │
               ▼
        ┌──────────────┐
        │     END      │
        └──────────────┘
```

# FIG.14

# FIG.15

## INTERNATIONAL SEARCH REPORT

| International application No. |
|---|
| **PCT/JP2023/032456** |

| A. | CLASSIFICATION OF SUBJECT MATTER |
|---|---|

*G01N 21/01*(2006.01)i; *G01N 21/64*(2006.01)i; *G01N 21/956*(2006.01)i; *H01L 21/66*(2006.01)i
FI: G01N21/01 D; G01N21/64 E; G01N21/956 A; H01L21/66 J

According to International Patent Classification (IPC) or to both national classification and IPC

| B. | FIELDS SEARCHED |
|---|---|

Minimum documentation searched (classification system followed by classification symbols)

G01N21/00-G01N21/958; G02B21/00-G02B21/36; G01B11/00-G01B11/30; H01L21/66

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

JSTPlus/JMEDPlus/JST7580 (JDreamIII); Scopus

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 8-35934 A (KABUSHIKI KAISHA KOBE SEIKO SHO) 06 February 1996 (1996-02-06) paragraphs [0005]-[0010], fig. 1-3 | 1, 4-8, 11 |
| A | | 2-3, 9-10, 12 |
| Y | JP 2007-127816 A (OLYMPUS CORPORATION) 24 May 2007 (2007-05-24) paragraph [0002] | 1, 4-8, 11 |
| A | | 2-3, 9-10, 12 |
| Y | JP 7-253547 A (NIKON CORPORATION) 03 October 1995 (1995-10-03) paragraph [0003] | 1, 4-8, 11 |
| A | | 2-3, 9-10, 12 |
| Y | JP 2006-30679 A (OLYMPUS CORPORATION) 02 February 2006 (2006-02-02) paragraphs [0002], [0005] | 1, 4-8, 11 |
| A | | 2-3, 9-10, 12 |

☑ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **27 October 2023** | **14 November 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT

International application No.

**PCT/JP2023/032456**

### C. DOCUMENTS CONSIDERED TO BE RELEVANT

| Category* | Citation of document, with indication, where appropriate, of the relevant passages | Relevant to claim No. |
|---|---|---|
| Y | JP 2015-22073 A (OLYMPUS CORPORATION) 02 February 2015 (2015-02-02) paragraphs [0006]-[0007], [0015]-[0036], [0043] | 1, 4-8, 11 |
| A | | 2-3, 9-10 |
| A | JP 2006-195390 A (OLYMPUS CORPORATION) 27 July 2006 (2006-07-27) entire text, all drawings | 1-12 |
| A | JP 10-206741 A (TOKYO KOKU KEIKI K.K.) 07 August 1998 (1998-08-07) entire text, all drawings | 1-12 |
| A | JP 2017-11100 A (PANASONIC CORPORATION) 12 January 2017 (2017-01-12) entire text, all drawings | 1-12 |
| A | JP 2018-14377 A (TORAY ENGINEERING CO., LTD.) 25 January 2018 (2018-01-25) entire text, all drawings | 1-12 |
| A | US 2020/0182606 A1 (ONTO INNOVATION INC.) 11 June 2020 (2020-06-11) entire text, all drawings | 1-12 |

Form PCT/ISA/210 (second sheet) (January 2015)

**INTERNATIONAL SEARCH REPORT**
Information on patent family members

International application No.

**PCT/JP2023/032456**

| Patent document cited in search report | | | Publication date (day/month/year) | Patent family member(s) | | | Publication date (day/month/year) |
|---|---|---|---|---|---|---|---|
| JP | 8-35934 | A | 06 February 1996 | (Family: none) | | | |
| JP | 2007-127816 | A | 24 May 2007 | (Family: none) | | | |
| JP | 7-253547 | A | 03 October 1995 | (Family: none) | | | |
| JP | 2006-30679 | A | 02 February 2006 | (Family: none) | | | |
| JP | 2015-22073 | A | 02 February 2015 | (Family: none) | | | |
| JP | 2006-195390 | A | 27 July 2006 | (Family: none) | | | |
| JP | 10-206741 | A | 07 August 1998 | (Family: none) | | | |
| JP | 2017-11100 | A | 12 January 2017 | (Family: none) | | | |
| JP | 2018-14377 | A | 25 January 2018 | WO | 2018/016154 | A1 | |
| | | | | entire text, all drawings | | | |
| | | | | TW | 201812943 | A | |
| | | | | CN | 109478523 | A | |
| | | | | KR | 10-2019-0031233 | A | |
| US | 2020/0182606 | A1 | 11 June 2020 | TW | 202024562 | A | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6798504 B

- US 7071451 B

**Non-patent literature cited in the description**

- **TOMOYUKI TANIKAWA et al.** Three-dimensional imaging of threading dislocations in GaN crystals using two-photon excitation photoluminescence. *Applied Physics Express*, 2018, vol. 11, 031004

- **MAYUKO TSUKAKOSHI et al.** Identification of Burgers vectors of threading dislocations in freestanding GaN substrates via multiphoton-excitation photoluminescence mapping. *Applied Physics Express*, 2021, vol. 14, 055504